# EUROPEAN PATENT APPLICATION

(11) **EP 4 289 618 A1**
(43) Date of publication of application: **13.12.2023**
(21) Application number: 22749676.7
(22) Date of filing: 31.01.2022
(51) Int. Cl.: B32B 27/00, C09D 5/00, C08K 5/07, C08L 83/04, C09D 183/04

(54) **UNDERCOAT AGENT COMPOSITION FOR INORGANIC SUBSTANCE LAYER LAMINATION, CURED PRODUCT THEREOF, AND METHOD FOR PRODUCING SAME**

(30) Priority: 05.02.2021 JP 2021017829
(71) Applicant: Toagosei Co., Ltd., Minato-ku Tokyo 105-8419 (JP)
(72) Inventor: IWASE, Yoshiaki, Nagoya-shi, Aichi 455-0026 (JP); FURUTA, Naomasa, Tokyo 105-8419 (JP)
(74) Representative: Rüger Abel Patentanwälte PartGmbB
(86) International application number: PCT/JP2022/003675
(87) International publication number: WO 2022/168804

(57) **Abstract**

An undercoat agent composition for layering an inorganic material layer, the composition being applied on a resin substrate, for layering an inorganic material layer on the resin substrate by a dry film-forming method, the composition including a polysiloxane compound represented by Formula (1) below, and at least one of a radical polymerization initiator or a cationic polymerization initiator:

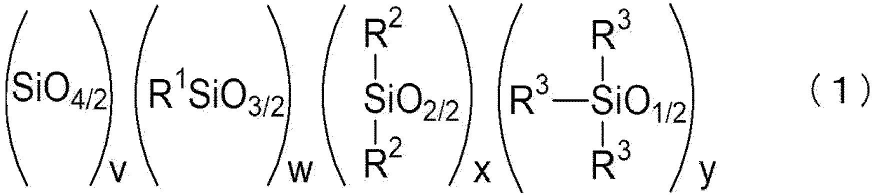

## Description

### Technical Field

The present disclosure relates to an undercoat agent composition for layering an inorganic material layer, a cured product thereof, and a production method thereof, and relates to a layered body that includes a cured product for layering an inorganic material layer, a resin substrate, and an inorganic material layer. More specifically, the present disclosure relates to an undercoat agent composition for layering an inorganic material layer, the composition including a polysiloxane compound and a polymerization initiator. The cured product of the undercoat agent composition for layering an inorganic material layer is useful, for example, as an undercoat for layering an inorganic material layer when preparing display substrates, touch panels, films with electrodes, lenses, and the like.

### Background Art

In recent years, layering inorganic material layers by a dry film-forming method or the like has been proposed in order to impart or improve various functions such as weather resistance, chemical resistance, hardness, scratch resistance, durability, heat resistance, electrical conductivity, gas barrier properties, antifouling properties, and antireflection properties on a surface of resin substrates.

Japanese Patent Application Laid-Open (JP-A) No. 2009-178904 discloses a decorative printed film layered body characterized by including a plastic film having a glass transition temperature of 70°C or higher, a transparent resin layer thereon that is formed by curing a photocurable resin composition containing a photocurable cage-type silsesquioxane resin, and a surface modification film layer on a surface thereof that is layered by a sputtering method.

Japanese Patent Application Laid-Open (JP-A) No. 2010-274562 discloses a gas barrier layered body characterized by including one or more combinations of an organic compound layer, a layer containing a polysilsesquioxane formed thereon, and an oxide-inorganic compound layer formed thereon by a chemical vapor deposition method.

Japanese Patent Application Laid-Open (JP-A) No. 2013-035274 discloses a layered body characterized in that a cured coating film layer from an active energy ray curable primer composition that contains a silsesquioxane compound having a (meth)acryloyloxy group, a photopolymerization initiator, and an unsaturated group-containing silicon-based surface conditioner, and an inorganic material layer that consists of a silicon oxide compound formed by a dry film-forming method are sequentially layered on a polycarbonate resin substrate.

### SUMMARY OF INVENTION

### Technical Problem

However, in those in which a cured product of the composition including a silsesquioxane disclosed in JP-A No. 2009-178904, JP-A No. 2010-274562, or JP-A No. 2013-035274 is used as a primer layer, adhesiveness to an inorganic material layer layered thereon was still insufficient, which was a problem in practical use.

According to one embodiment of the present disclosure, an undercoat agent composition for layering an inorganic material layer that can provide a cured product (primer layer) having favorable adhesiveness to an inorganic material layer that is layered by a dry film-forming method, a cured product thereof, a layered body using the same, and methods of producing them are provided.

### Solution to Problem

The present disclosure includes the following aspects [1] to [11].
[1] An undercoat agent composition for layering an inorganic material layer, the composition being applied on a resin substrate, for layering an inorganic material layer on the resin substrate by a dry film-forming method, the composition including a polysiloxane compound represented by Formula (1) below, and at least one of a radical polymerization initiator or a cationic polymerization initiator: 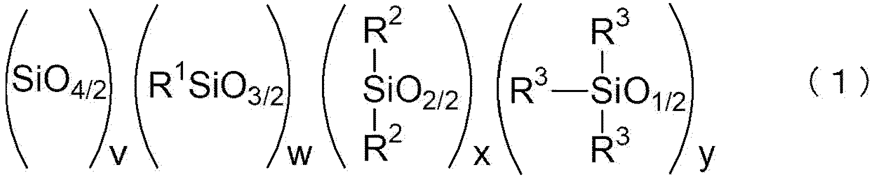 in which, in Formula (1), each of R¹, R², and R³ independently represents an alkyl group having 1 to 10 carbon atoms, an aralkyl group having 7 to 10 carbon atoms, an aryl group having 6 to 10 carbon atoms, an unsaturated hydrocarbon group having 2 to 8 carbon atoms, or a monovalent organic group having a (meth)acryloyl group, an epoxy group, or an oxetanyl group; each of the alkyl group, the aralkyl group, the aryl group, the unsaturated hydrocarbon group, the (meth)acryloyl group, the epoxy group, and the oxetanyl group may be substituted with at least one selected from the group consisting of a halogen atom, a hydroxy group, an alkoxy group, an aryloxy group, an aralkyloxy group, and an oxy group; at least one of R¹, R², or R³ is a monovalent organic group having a (meth)acryloyl group, an epoxy group, or an oxetanyl group; R¹, R², and R³ may be the same as or different from each other; each of v, w, x, and y means a ratio with respect to a total amount of v, w, x, and y; w represents a positive number of 1 or less; and each of v, x, and y independently represents 0 or a positive number of less than 1.
[2] The undercoat agent composition for layering an inorganic material layer according to [1], in which x in Formula (1) represents a positive number.
[3] The undercoat agent composition for layering an inorganic material layer according to [1] or [2], in which the dry film-forming method is a physical vapor deposition method.
[4] The undercoat agent composition for layering an inorganic material layer according to any one of [1] to [3], which satisfies 0.3 ≤ {w/(v+w+x+y)} ≤ 1.0 and 0 ≤ {x/(v+w+x+y)} ≤ 0.7.
[5] The undercoat agent composition for layering an inorganic material layer according to any one of [1] to [3], which satisfies 0.5 ≤ {w/(v+w+x+y)} ≤ 1.0 and 0 ≤ {y/(v+w+x+y)} ≤ 0.5.
[6] The undercoat agent composition for layering an inorganic material layer according to any one of [1] to [5], in which the polysiloxane compound has a viscosity of from 10 to 1,000,000 mPa·s at 25°C.
[7] A cured product for layering an inorganic material layer, which is a cured product of the undercoat agent composition for layering an inorganic material layer according to any one of [1] to [6].
[8] A layered body, including the cured product for layering an inorganic material layer according to [7], a resin substrate, and an inorganic material layer.
[9] The layered body according to [8], in which 5 or less out of 25 squares are peeled off in an evaluation of adhesiveness of the inorganic material layer to the cured product for layering an inorganic material layer in a cross-cut peeling test.
[10] A method of producing the cured product for layering an inorganic material layer according to [7], the method including a step of irradiating the undercoat agent composition for layering an inorganic material layer according to any one of [1] to [6] with an active energy ray, to cure the composition.
[11] A method of producing the layered body according to [8] or [9], the method including a step of irradiating the undercoat agent composition for layering an inorganic material layer according to any one of [1] to [6] with an active energy ray, to cure the composition.

### Advantageous Effects of Invention

According to one embodiment of the present disclosure, an undercoat agent composition for layering an inorganic material layer that can provide a cured product (primer layer) having favorable adhesiveness to an inorganic material layer that is layered by a dry film-forming method, a cured product thereof, a layered body using the same, and methods of producing them are provided.

### DESCRIPTION OF EMBODIMENTS

The present disclosure will be described in detail below.

"%" means "% by weight" unless otherwise specified, "parts" means "parts by weight", and "ppm" means "ppm by weight". In addition, in the present disclosure, the description of "X (lower limit) to Y (upper limit)" representing a numerical range represents "X or more but Y or less", and the description of "Y (upper limit) to X (lower limit)" represents "Y or less but X or more". That is, each of them represents a numerical range including the upper limit and the lower limit. Furthermore, in the present disclosure, a combination of two or more of the preferable aspects described later is also a preferable aspect.

The polysiloxane compound, the polymerization initiator, the undercoat agent composition for layering an inorganic material layer, the cured product, the layered body, and the methods of producing the cured product and the layered body will be described below.

### 1. Polysiloxane compound

The polysiloxane compound according to the present disclosure is a polysiloxane compound represented by Formula (1) below, in which the polysiloxane compound has at least a (meth)acryloyl group, an epoxy group, or an oxetanyl group, and in which w represents a positive number of 1 or less.

Here, the (meth)acryloyl group means an acryloyl group or a methacryloyl group, and the same applies hereinafter.

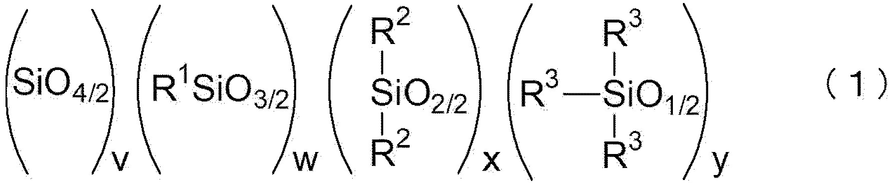

Constituent units that the polysiloxane compound according to the present disclosure can have are referred to as constituent units (a) to (d), respectively, and will be described below.

### Constituent unit (a): (SiO_{4/2})ᵥ

(SiO_{4/2})_{V}

### Constituent unit (b): (R¹SiO_{3/2})_{w}

(R¹SiO_{3/2})_{W}

### Constituent unit (c): (R²₂SiO_{2/2})ₓ

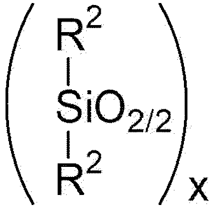

### Constituent unit (d): (R³₃SiO_{1/2})_{y}

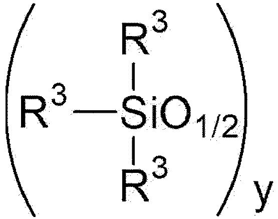

The polysiloxane compound according to the present disclosure can include the constituent units (a) to (d) described above.

In Formula (1), each of v, w, x, and y means a ratio with respect to a total amount of v, w, x, and y, w represents a positive number of 1 or less, and each of v, x, and y independently represents 0 or a positive number of less than 1.

That is, each of v, w, x, and y in Formula (1) represents a molar ratio of each constituent unit with respect to the constituent units (a) to (d). In other words, it is as follows.
v/(v+w+x+y) represents a molar ratio of the constituent unit (a) with respect to the constituent units (a) to (d),
w/(v+w+x+y) represents a molar ratio of the constituent unit (b) with respect to the constituent units (a) to (d),
x/(v+w+x+y) represents a molar ratio of the constituent unit (c) with respect to the constituent units (a) to (d),
y/(v+w+x+y) represents a molar ratio of the constituent unit (d) with respect to the constituent units (a) to (d).

In Formula (1), each of v, w, x, and y represents a relative molar ratio of each constituent unit contained in the polysiloxane compound according to the present disclosure represented by Formula (1). That is, the molar ratio is a relative ratio of repeating numbers of each constituent unit represented by Formula (1). The molar ratio can be determined from NMR analysis values of the polysiloxane compound according to the present disclosure. Further, when the reaction rate of each raw material of the polysiloxane compound according to the present disclosure is known or when the yield is 100%, the molar ratio can be determined from the charged amount of the raw materials.

For each of the constituent units (a), (b), (c), and (d) in Formula (1), there may be only one corresponding constituent unit, or there may be two or more corresponding constituent units. For example, one constituent unit corresponding to the constituent unit (a) may be present, or two or more constituent units corresponding to the constituent unit (a) may be present. The sequence in Formula (1) indicates a composition of the constituent units, but does not mean a sequence of them. Therefore, the condensation form of the constituent units in the polysiloxane compound according to the present disclosure does not necessarily have to follow the sequence in Formula (1).

### 1-1. Constituent unit (a): (SiO_{4/2})ᵥ

The constituent unit (a) is a so-called Q unit having four O_{1/2} (two oxygen atoms) with respect to one silicon atom. The Q unit means a unit having four O_{1/2} with respect to one silicon atom.

The ratio of the constituent unit (a) in the polysiloxane compound according to the present disclosure, that is, (v/(v+w+x+y)) represents 0 or a positive number of less than 1. Considering the viscosity of the polysiloxane compound according to the present disclosure and the flexibility of its cured product, the molar ratio (v/(v+w+x+y)) with respect to the constituent units (a) to (d) is preferably 0.6 or less, more preferably 0.3 or less, and still more preferably 0. Here, a molar ratio of 0 means that the constituent unit is not included, and the same applies hereinafter.

### 1-2. Constituent unit (b): (R¹SiO_{3/2})_{w}

The constituent unit (b) is a T unit having three O_{1/2} (1.5 oxygen atoms) with respect to one silicon atom, and has R¹ bonded to the silicon atom.

R¹ represents an alkyl group having 1 to 10 carbon atoms, an aralkyl group having 7 to 10 carbon atoms, an aryl group having 6 to 10 carbon atoms, an unsaturated hydrocarbon group having 2 to 8 carbon atoms, or a monovalent organic group having a (meth)acryloyl group, an epoxy group, or an oxetanyl group.

Each of the alkyl group, the aralkyl group, the aryl group, the unsaturated hydrocarbon group, the (meth)acryloyl group, the epoxy group, and the oxetanyl group may be substituted with at least one selected from the group consisting of a halogen atom, a hydroxy group, an alkoxy group, an aryloxy group, an aralkyloxy group, and an oxy group.

At least one of R¹, R², or R³ in the polysiloxane compound represented by Formula (1) is a monovalent organic group having a (meth)acryloyl group, an epoxy group, or an oxetanyl group, and R¹, R², and R³ may be the same as or different from each other. In the case in which multiple groups corresponding to R¹ are present in one molecule, the multiple R¹ may be the same as or different from each other.

At least one of R¹, R², or R³ in the polysiloxane compound represented by Formula (1) is a monovalent organic group having a (meth)acryloyl group, an epoxy group, or an oxetanyl group, it is preferable that at least one thereof is a monovalent organic group having a (meth)acryloyl group or an oxetanyl group, it is more preferable that at least one thereof is a monovalent organic group having an acryloyl group or an oxetanyl group, and it is still more preferable that at least one thereof is a monovalent organic group having an acryloyl group.

Each of the alkyl group having 1 to 10 carbon atoms, the aralkyl group having 7 to 10 carbon atoms, and the unsaturated hydrocarbon group having 2 to 8 carbon atoms in R¹ may be linear or branched, or may have a ring structure.

The alkyl group having 1 to 10 carbon atoms in R¹ is not particularly limited, but is preferably an alkyl group having 1 to 4 carbon atoms, and more preferably a methyl group.

The aralkyl group having 7 to 10 carbon atoms in R¹ is not particularly limited, but is preferably a phenylalkyl group, and more preferably a benzyl group.

The aryl group having 6 to 10 carbon atoms in R¹ is not particularly limited, but is preferably a phenyl group.

The unsaturated hydrocarbon group having 2 to 8 carbon atoms in R¹ is not particularly limited, but is preferably a vinyl group, an allyl group, an ethynyl group, or a styryl group, and more preferably a vinyl group.

The monovalent organic group having a (meth)acryloyl group in R¹ is not particularly limited, but is preferably a group represented by Formula (2) below. In the present disclosure, the "(meth)acryloyl group" collectively means an acryloyl group and a methacryloyl group.

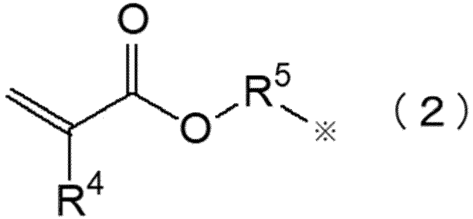

[In Formula (2), R⁴ represents a hydrogen atom or a methyl group, R⁵ represents an alkylene group having 1 to 10 carbon atoms, and * represents a bonding site.]

R⁵ in Formula (2) is not particularly limited, but is preferably an alkylene group having 2 to 8 carbon atoms, and more preferably a propylene group.

The monovalent organic group having an epoxy group in R¹ is not particularly limited, but is preferably a glycidyloxyalkyl group, and more preferably a glycidyloxypropyl group.

The monovalent organic group having an oxetanyl group in R¹ is not particularly limited, but is preferably a group represented by Formula (3) below.

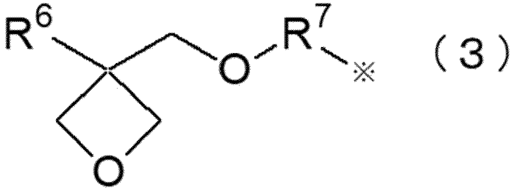

[In Formula (3), R⁶ represents a hydrogen atom or an alkyl group having 1 to 6 carbon atoms, R⁷ represents an alkylene group having 1 to 10 carbon atoms, and * represents a bonding site.]

R⁶ in Formula (3) is not particularly limited, but is preferably a hydrogen atom, a methyl group, or an ethyl group, and more preferably an ethyl group.

R⁷ in Formula (3) is not particularly limited, but is preferably an alkylene group having 2 to 8 carbon atoms, and more preferably a propylene group.

The ratio of the constituent unit (b) in the polysiloxane compound according to the present disclosure is not particularly limited, but the molar ratio (w/(v+w+x+y)) with respect to the constituent units (a) to (d) is a positive number of 1 or less, preferably from 0.3 to 1.0, more preferably from 0.5 to 0.95, and still more preferably from 0.6 to 0.9, considering at least one of weather resistance, chemical resistance, hardness, scratch resistance, durability, heat resistance, or oxidation resistance of the polysiloxane compound according to the present disclosure and its cured product.

### 1-3. Constituent unit (c): (R²₂SiO_{2/2})ₓ

The constituent unit (c) is a so-called D unit having two O_{1/2} (one oxygen atom) with respect to one silicon atom. The D unit means a unit having two O_{1/2} with respect to one silicon atom.

Each of R² independently represents an alkyl group having 1 to 10 carbon atoms, an aralkyl group having 7 to 10 carbon atoms, an aryl group having 6 to 10 carbon atoms, an unsaturated hydrocarbon group having 2 to 8 carbon atoms, or a monovalent organic group having a (meth)acryloyl group, an epoxy group, or an oxetanyl group.

Each of the alkyl group, the aralkyl group, the aryl group, the unsaturated hydrocarbon group, the (meth)acryloyl group, the epoxy group, and the oxetanyl group may be substituted with at least one selected from the group consisting of a halogen atom, a hydroxy group, an alkoxy group, an aryloxy group, an aralkyloxy group, and an oxy group.

At least one of R¹, R², or R³ in the polysiloxane compound represented by Formula (1) is a monovalent organic group having a (meth)acryloyl group, an epoxy group, or an oxetanyl group, R¹, R², and R³ may be the same as or different from each other. Examples of each of these substituents include substituents similar to those exemplified for R¹ of the constituent unit (b) described above.

Since the constituent unit (c) is a D unit, it contributes to lowering the viscosity of the polysiloxane compound according to the present disclosure and improving at least one of the flexibility, heat resistance, or oxidation resistance of its cured product.

Each of R² is independently preferably a methyl group or a phenyl group and more preferably a methyl group, from the viewpoints of heat resistance, availability of raw materials, and imparting flexibility to the cured product.

The ratio of the constituent unit (c) in the polysiloxane compound according to the present disclosure, that is, (x/(v+w+x+y)) represents 0 or a positive number of less than 1. Considering the viscosity reduction of the polysiloxane compound according to the present disclosure and at least one of the hardness, scratch resistance, weather resistance, or flexibility of its cured product, the molar ratio (x/(v+w+x+y)) with respect to the constituent units (a) to (d) is preferably 0 ≤ {x/(v+w+x+y)} ≤ 0.7, more preferably from 0.05 to 0.6, and still more preferably from 0.1 to 0.5. However, when x is 0, at least one of R¹ in the constituent unit (b) described above or R³ in the constituent unit (d) described later is a monovalent organic group having a (meth)acryloyl group, an epoxy group, or an oxetanyl group.

In particular, when the value of x/(v+w+x+y) is in a range of from 0.05 to 0.6, the adhesiveness of the cured product to the inorganic material layer is particularly favorable, the inorganic material layer of the resulting layered body also exhibits favorable scratch resistance, and both of these physical properties can be achieved, which is preferable.

### 1-4. Constituent unit (d): (R³₃SiO_{1/2})_{z}

The constituent unit (d) is a so-called M unit having one O_{1/2} (0.5 oxygen atoms) with respect to one silicon atom. The M unit means a unit having one O_{1/2} with respect to one silicon atom.

Each of R³ independently represents an alkyl group having 1 to 10 carbon atoms, an aralkyl group having 7 to 10 carbon atoms, an aryl group having 6 to 10 carbon atoms, an unsaturated hydrocarbon group having 2 to 8 carbon atoms, or a monovalent organic group having a (meth)acryloyl group, an epoxy group, or an oxetanyl group.

Each of the alkyl group, the aralkyl group, the aryl group, the unsaturated hydrocarbon group, the (meth)acryloyl group, the epoxy group, and the oxetanyl group may be substituted with at least one selected from the group consisting of a halogen atom, a hydroxy group, an alkoxy group, an aryloxy group, an aralkyloxy group, and an oxy group.

At least one of R¹, R², or R³ in the polysiloxane compound represented by Formula (1) is a monovalent organic group having a (meth)acryloyl group, an epoxy group, or an oxetanyl group, R¹, R², and R³ may be the same as or different from each other, and R³ in one molecule may be the same as or different from each other. Examples of each of these substituents include substituents similar to those exemplified for R¹ of the constituent unit (b) described above.

Since the constituent unit (d) is an M unit, it contributes to lowering the viscosity of the polysiloxane compound according to the present disclosure and improving the flexibility of its cured product.

Each of R³ is independently preferably a methyl group, a phenyl group, or a vinyl group and more preferably a methyl group or a vinyl group, from the viewpoints of at least one of heat resistance, availability of raw materials, curability of the undercoating agent composition, or imparting flexibility to the cured product.

The ratio of the constituent unit (d) in the polysiloxane compound according to the present disclosure, that is, (y/(v+w+x+y)) represents 0 or a positive number of less than 1. Considering the viscosity reduction of the polysiloxane compound according to the present disclosure and at least one of the hardness, weather resistance, or flexibility of its cured product, the molar ratio (y/(v+w+x+y)) with respect to the constituent units (a) to (d) is preferably 0 ≤ {y/(v+w+x+y)} ≤ 0.5, more preferably from 0 to 0.4, and still more preferably from 0 to 0.3. However, when y is 0, at least one of R¹ in the constituent unit (b) described above or R² in the constituent unit (c) described above is a monovalent organic group having a (meth)acryloyl group, an epoxy group, or an oxetanyl group.

### 1-5. Other constituent unit (e)

The polysiloxane compound according to the present disclosure may further include (R⁸O_{1/2}) (hereinafter, referred to as constituent unit (e)) as a constituent unit that does not contain Si.

Here, R⁸ represents a hydrogen atom or an alkyl group having 1 to 6 carbon atoms, and may be either an aliphatic group or an alicyclic group, and may be linear or branched. Specific examples of alkyl groups include a methyl group, an ethyl group, a propyl group, a butyl group, a pentyl group, and a hexyl group.

This constituent unit is: an alkoxy group that is a hydrolyzable group contained in the raw material monomer to be described later, or an alkoxy group that is produced by substituting an alcohol contained in the reaction solvent with a hydrolyzable group of the raw material monomer, in which the alkoxy group remains in the molecule without hydrolysis/polycondensation; or a hydroxyl group remaining in the molecule without polycondensation after hydrolysis.

### 1-6. Molecular weight, etc.

The weight average molecular weight (hereinafter, also referred to as "Mw") of the polysiloxane compound according to the present disclosure is not particularly limited, but is preferably in a range of from 300 to 10,000. Such a polysiloxane compound is liquid, has a low viscosity suitable for handling, is easily dissolved in an organic solvent, the viscosity of its solution is easy to handle, and is excellent in storage stability. The Mw is more preferably from 500 to 8,000, still more preferably from 600 to 7,000, and particularly preferably from 700 to 6,000.

The Mw in the present disclosure means a value obtained by converting a molecular weight measured by GPC (gel permeation chromatography) using polystyrene as a standard substance. The Mw can be determined, for example, under the measurement conditions in [Examples] described later.

The state of the polysiloxane compound according to the present disclosure is not particularly limited, and examples thereof include liquid, solid, and semi-solid. The polysiloxane compound according to the present disclosure is preferably liquid, and its viscosity is not particularly limited. For example, the viscosity at 25°C is preferably from 10 to 1,000,000 mPa·s, more preferably from 100 to 100,000 mPa s, further preferably from 300 to 30,000 mPa·s, further more preferably from 400 to 10,000 mPa·s, and particularly preferably from 500 to 5,000 mPa s. In particular, when the viscosity is 10,000 mPa s or less, workability such as application is excellent even in a non-solvent system, and organic solvents are not discharged into the environment, so environmental resistance is also excellent, which is preferable. In addition, if the viscosity is low, the surface of the applied and cured undercoat for layering an inorganic material tends to be smooth, which is preferable for layering an inorganic material layer.

In the present disclosure, the viscosity means a value measured at 25°C using an E-type viscometer (cone plate type viscometer; for example, TVE22H-type viscometer, manufactured by Toki Sangyo Co., Ltd.).

### 2. Method of producing polysiloxane compound according to the present disclosure

The polysiloxane compound according to the present disclosure can be produced by known methods. The method of producing the polysiloxane compound is not particularly limited, but is specifically disclosed as a method of producing a polysiloxane, for example, in JP-A No. H11-116682, JP-A No. 2000-044689, International publication (WO) No. 2004/076534, International publication (WO) No. 2009/090916, International publication (WO) No. 2009/131038, International publication (WO) No. 2012/090707, and International publication (WO) No. 2013/031798.

The polysiloxane compound according to the present disclosure can be produced, for example, by the following method.

That is, the method of producing the polysiloxane compound according to the present disclosure may include a condensation step of carrying out hydrolysis /polycondensation reaction of a raw material monomer that gives the constituent unit in Formula (1) by condensation using a suitable acid or base as a reaction catalyst in a suitable reaction solvent. In this condensation step, for example, it is possible to use a silicon compound having four siloxane bond-forming groups (hereinafter, referred to as "Q monomer") that forms the constituent unit (a) (Q unit), a silicon compound having three siloxane bond-forming groups (hereinafter, referred to as "T monomer") that forms the constituent unit (b) (T unit), a silicon compound having two siloxane bond-forming groups (hereinafter, referred to as "D monomer") that forms the constituent unit (c) (D unit), and a silicon compound having one siloxane bond-forming group (hereinafter, referred to as "M monomer") that forms the constituent unit (d) (M unit).

The method of producing the polysiloxane compound according to the present disclosure preferably includes, after carrying out hydrolysis/polycondensation reaction of raw material monomers under the presence of a reaction solvent, a distillation step of distilling off the reaction solvent, by-products, residual monomers, water, etc. in the reaction solution. Moreover, the method may include a washing step of washing the reaction solution or reaction concentrate with water or the like, as appropriate.

### 2-1. Raw material monomer

The siloxane bond-forming group contained in the Q monomer, the T monomer, the D monomer, and the M monomer as the raw material monomers is at least one of a hydroxyl group or a hydrolyzable group. Examples of the hydrolyzable group include a halogeno group, an alkoxy group, and a siloxy group. The hydrolyzable group is preferably an alkoxy group and more preferably an alkoxy group having 1 to 3 carbon atoms, since it has favorable hydrolyzability and does not produce an acid by-product in the condensation step. Further, for the M monomer, a siloxy group is preferable as the hydrolyzable group because of the availability of raw materials, and a disiloxane consisting of two constituent units (d) can be used.

In the condensation step, the siloxane bond-forming group of the Q monomer, the T monomer, and the D monomer corresponding to each constituent unit is preferably an alkoxy group, and the siloxane bond-forming group contained in the M monomer is preferably an alkoxy group or a siloxy group. The monomers corresponding to each constituent unit may be used singly, or in combination of two or more thereof.

Examples of the Q monomer that provides the constituent unit (a) include tetramethoxysilane, tetraethoxysilane, tetrapropoxysilane, and tetrabutoxysilane.

Examples of the T monomer that provides the constituent unit (b) include trimethoxyvinylsilane, triethoxyvinylsilane, trichlorovinylsilane, trimethoxyallylsilane, triethoxyethynylsilane, (p-styryl)trimethoxysilane, (p-styryl)triethoxysilane, (3-methacryloyloxypropyl)trimethoxysilane, (3-methacryloyloxypropyl)triethoxysilane, (3-acryloyloxypropyl)trimethoxysilane, (3-acryloyloxypropyl)triethoxysilane, (8-methacryloyloxyoctyl))trimethoxysilane, (8-acryloyloxyoctyl)trimethoxysilane, 3-ethyl-3-[{3-(trimethoxysilyl)propoxy}methyl]oxetane, 3-ethyl-3-[{3-(triethoxysilyl)propoxy}methyl]oxetane, 3-{3-(triethoxysilyl)propoxy}oxetane, (3-glycidyloxypropyl)trimethoxysilane, (3-glycidyloxypropyl)triethoxysilane, {2-(3,4-epoxycyclohexyl)ethyl}trimethoxysilane, methyltrimethoxysilane, methyltriethoxysilane, methyltripropoxysilane, methyltriisopropoxysilane, methyltrichlorosilane, ethyltrimethoxysilane, ethyltriethoxysilane, propyltriethoxysilane, butyltrimethoxysilane, octyltriethoxysilane, decyltrimethoxysilane, cyclohexyltrimethoxysilane, cyclohexyltriethoxysilane, phenyltrimethoxysilane, phenyltriethoxysilane, phenyltrichlorosilane, benzyltriethoxysilane, and benzyltrichlorosilane.

Examples of the D monomer that provides the constituent unit (c) include dimethoxymethylvinylsilane, dimethoxyethylvinylsilane, diethoxymethylvinylsilane, dichloromethylvinylsilane, dimethoxyallylmethylsilane, dimethoxyallylethylsilane, diethoxyethynylmethylsilane, diethoxyethynylethyl silane, (p-styryl)dimethoxymethylsilane, (p-styryl)dimethoxyethylsilane, (p-styryl)diethoxymethylsilane, (3-methacryloyloxypropyl)dimethoxymethylsilane, (3-methacryloyloxypropyl)diethoxymethylsilane, (3-methacryloyloxypropyl)diethoxymethylsilane, (3-methacryloyloxypropyl)diethoxyethylsilane, (3-acryloyloxypropyl)dimethoxymethylsilane, (3-acryloyloxypropyl)diethoxymethylsilane, (8-methacryloyloxyoctyl)dimethoxymethylsilane, (8-acryloyloxyoctyl)dimethoxymethylsilane, 3-ethyl-3-[{3-(dimethoxymethylsilyl)propoxy}methyl]oxetane, 3-ethyl-3-[{3-(diethoxymethylsilyl)propoxy}methyl]oxetane, 3-{3-(diethoxymethylsilyl)propoxy}oxetane, (3-glycidyloxypropyl)dimethoxymethylsilane, (3-glycidyloxypropyl)dimethoxyethylsilane, (3-glycidyloxypropyl)diethoxymethylsilane, {2-(3,4-epoxycyclohexyl)ethyl}dimethoxymethylsilane, dimethoxydimethylsilane, dimethoxydiethylsilane, diethoxydimethylsilane, diethoxydiethylsilane, dipropoxydimethylsilane, dipropoxydiethylsilane, diisopropoxydimethylsilane, dichlorodimethylsilane, diethoxymethylpropylsilane, dimethoxybutylmethylsilane, diethoxyoctylmethylsilane, dimethoxydecylmethylsilane, dimethoxycyclohexylmethylsilane, diethoxycyclohexylmethylsilane, dimethoxymethylphenylsilane, diethoxymethylphenylsilane, dichloromethylphenylsilane, dimethoxybenzylmethylsilane, diethoxybenzylmethylsilane, and dichlorobenzylmethylsilane.

Furthermore, a D unit oligomer having at least one of a silanol group or an alkoxysilyl group capable of hydrolysis/condensation reaction, a so-called silicone, can be used as the D monomer that provides the constituent unit (c) in the present disclosure as a raw material for producing the polysiloxane compound represented by Formula (1). Examples thereof include a silanol-terminated dimethylsilicone, a methoxy-terminated dimethylsilicone, a dimethylsilicone having both silanol and methoxy groups at the terminal, a silanol-terminated methylphenylsilicone, a methoxy-terminated methylphenylsilicone, and a methyl phenyl silicone having both silanol and methoxy groups at the terminal, and the molecular weight thereof is arbitrarily selected. In addition, these raw material silicones may contain cyclic siloxanes.

Examples of the M monomer that provides the constituent unit (d) include hexamethyldisiloxane, hexaethyldisiloxane, hexapropyldisiloxane, and 1,3-divinyl-1,1,3,3-tetramethyldisiloxane, each of which provides two constituent units (d) by hydrolysis, as well as methoxytrimethylsilane, ethoxytrimethylsilane, propoxytrimethylsilane, isopropoxytrimethylsilane, ethoxydimethylethylsilane, methoxydimethylphenylsilane, ethoxydimethylphenylsilane, chlorodimethylvinylsilane, chlorotrimethylsilane, dimethylvinylsilanol, trimethylsilanol, triethylsilanol, tripropylsilanol, tributylsilanol, ethoxydimethylpropylsilane, methoxybutyldimethylsilane, ethoxyoctyldimethylsilane, methoxydecyldimethylsilane, methoxycyclohexyldimethylsilane, methoxybenzyldimethylsilane, chlorobenzyldimethylsilane, methoxydimethylvinylsilane, methoxydiethylvinylsilane, ethoxydimethylvinylsilane, chlorodimethylvinylsilane, methoxyallyldimethylsilane, ethoxyethynyldimethylsilane, (p-styryl)methoxydimethylsilane, (p-styryl)ethoxydimethylsilane, (3-methacryloyloxypropyl)methoxydimethylsilane, (3-methacryloyloxypropyl)ethoxydimethylsilane, (3-acryloyloxypropyl)methoxydimethylsilane, (3-acryloyloxypropyl)ethoxydimethyl silane, (8-methacryloyloxyoctyl)methoxydimethylsilane, (8-acryloyloxyoctyl)methoxydimethylsilane, 3-ethyl-3-[{3-(methoxydimethylsilyl)propoxy}methyl]oxetane, 3-ethyl-3-[{3-(ethoxydimethylsilyl)propoxy}methyl]oxetane, 3-{3-(ethoxydimethylsilyl)propoxy}oxetane, (3-glycidyloxypropyl)methoxydimethylsilane, (3-glycidyloxypropyl)ethoxydimethylsilane, and {2-(3,4-epoxycyclohexyl)ethyl}methoxydimethylsilane.

Examples of compounds that react with the raw material monomer to provide the constituent unit (e) include water and alcohols such as methanol, ethanol, 1-propanol, 2-propanol, and 2-butanol.

The charge ratio of the Q monomer, the T monomer, the D monomer, and the M monomer, which are raw material monomers, may be appropriately set according to the desired values of v to y in Formula (1) for the polysiloxane compound according to the present disclosure.

Further, the polysiloxane compound represented by Formula (1) may contain a ring-opened group obtained by addition of an acid or the like to the oxetanyl group and the epoxy group among the side chain functional groups derived from the monomer used for production, or may contain a hydroxyalkyl group produced by decomposition of the monovalent organic group having a (meth)acryloyl group, or may contain a group obtained by addition of an acid or the like to the unsaturated hydrocarbon group or the like. Specific example thereof include those containing, as a part of Formula (1), at least one of a structure represented by Formula (A) below or a structure represented by Formula (B) below. The content thereof may be 50 mol% or less, is preferably 30 mol% or less, and is more preferably 10 mol% or less, with respect to the monovalent organic group having an oxetanyl group derived from the raw material or the monovalent organic group having a (meth)acryloyl group. Either Formula (A) or Formula (B) is exemplified as a T unit, but may be a D unit or may be an M unit.

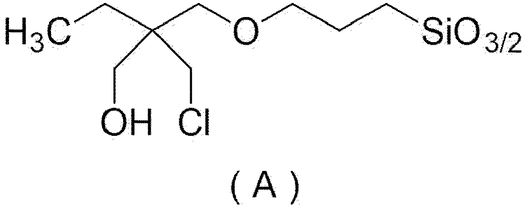

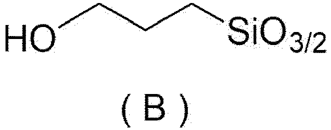

### 2-2. Reaction solvent

In the condensation step, alcohol can be used as a reaction solvent. Alcohol is a narrowly defined alcohol represented by a general formula R-OH, and is a compound having no functional groups other than an alcoholic hydroxyl group.

Alcohol is not particularly limited, but specific examples thereof include methanol, ethanol, 1-propanol, 2-propanol, 2-butanol, 2-pentanol, 3-pentanol, 2-methyl-2-butanol, 3-methyl-2-butanol, cyclopentanol, 2-hexanol, 3-hexanol, 2-methyl-2-pentanol, 3-methyl-2-pentanol, 2-methyl-3-pentanol, 3-methyl-3-pentanol, 2-ethyl-2-butanol, 2,3-dimethyl-2-butanol, cyclohexanol, and secondary alcohols or tertiary alcohols having 7 to 10 carbon atoms. Among these, secondary alcohols such as 2-propanol, 2-butanol, 2-pentanol, 3-pentanol, 3-methyl-2-butanol, cyclopentanol, 2-hexanol, 3-hexanol, 3-methyl-2-pentanol, and cyclohexanol are preferably used.

In the condensation step, these alcohols can be used singly or in combination of two or more. More preferred alcohols are compounds capable of dissolving the required concentration of water in the condensation step. Alcohols with such properties are compounds having a water solubility of 10 g or more per 100 g of alcohol at 20°C.

The amount of the alcohol used in the condensation step is, including additional input during the hydrolysis/polycondensation reaction, 0.5% by mass or more with respect to the total amount of all reaction solvents, as a result of which gelation of the produced polysiloxane compound according to the present disclosure can be suppressed. The usage amount is preferably from 1% by mass to 60% by mass, and more preferably from 3% by mass to 40% by mass.

The reaction solvent used in the condensation step may be alcohol alone, or may be a mixed solvent with at least one co-solvent. The co-solvent may be either a polar solvent, a non-polar solvent, or a combination of both. Preferred examples of polar solvents include diols having 2 to 20 carbon atoms, ethers, amides, ketones, esters, and cellosolves.

Examples of non-polar solvents include, but are not limited to, aliphatic hydrocarbons, alicyclic hydrocarbons, aromatic hydrocarbons, and chlorinated hydrocarbons. Such a non-polar solvent is not particularly limited, but for example, n-hexane, isohexane, cyclohexane, heptane, toluene, xylene, methylene chloride and the like are preferable because they azeotrope with water. When these compounds are used in combination, water can be efficiently distilled off when the reaction solvent is removed from the reaction mixture containing the polysiloxane compound by distillation after the condensation step. As the non-polar solvent, xylene, which is an aromatic hydrocarbon, is particularly preferred because of its relatively high boiling point.

### 2-3. Water and catalyst for hydrolysis reaction

The hydrolysis/polycondensation reaction in the condensation step proceeds under the presence of water.

The amount of water used to hydrolyze the hydrolyzable groups contained in the raw material monomers is preferably from 0.5 to 5 times the moles and more preferably from 1 to 2 times the moles with respect to the hydrolyzable groups.

In addition, the hydrolysis/polycondensation reaction of the raw material monomers may be carried out without a catalyst or with a catalyst. When using a catalyst, an acid catalyst or a base catalyst can be normally used. Examples of acid catalysts include, but are not particularly limited, inorganic acids such as sulfuric acid, nitric acid, hydrochloric acid, and phosphoric acid; and organic acids such as formic acid, acetic acid, oxalic acid, and p-toluenesulfonic acid. Examples of base catalysts include, but are not particularly limited, ammonia, tetramethylammonium hydroxide, sodium hydroxide, potassium hydroxide, sodium carbonate, and potassium carbonate.

The usage amount of the catalyst is preferably an amount corresponding to 0.01 to 20 mol% and more preferably an amount corresponding to 0.1 to 10 mol%, with respect to the total amount of silicon atoms contained in the raw material monomers.

### 2-4. Other additives

The completion of the hydrolysis/polycondensation reaction in the condensation step can be appropriately detected by methods described in various publications. In the condensation step of producing the polysiloxane compound according to the present disclosure, an auxiliary agent can be added to the reaction system.

Examples of auxiliary agents include defoaming agents that suppress foaming of the reaction solution, scale control agents that prevent scale from adhering to the reactor or the stirring shafts, and polymerization inhibitors. The usage amount of these auxiliary agents is arbitrary, but is preferably from about 1 to about 100% by weight with respect to the concentration of the polysiloxane compound according to the present disclosure in the reaction mixture.

### 2-5. Distillation of reaction solvent, etc.

After the condensation step in the production of the polysiloxane compound according to the present disclosure, a distillation step of distilling off the reaction solvent, by-products, residual monomers, water, catalysts, and the like contained in the reaction solution obtained from the condensation step is provided, whereby the stability of the produced polysiloxane compound according to the present disclosure can be improved. Distillation can be usually carried out under normal pressure or reduced pressure, can be usually carried out at room temperature or under heating, and can also be carried out under cooling.

Also, the remaining catalyst may be neutralized before distilling off the reaction solvent or the like. The reaction solution or the reaction solution after neutralization may be washed with water, followed by distilling off the solvent or the like, or the reaction solution or the reaction solution after neutralization may be concentrated, followed by washing with water. Commonly used aqueous media such as pure water and saturated saline can be used for washing with water.

### 3. Polymerization initiator

The polymerization initiator included in the undercoat agent composition for layering an inorganic material layer of the present disclosure is not particularly limited, and a known polymerization initiator used during polymerization reaction can be used. At least one of an active energy ray polymerization initiator or a thermal polymerization initiator can be arbitrarily selected and used according to usage conditions. An active energy ray polymerization initiator is more preferable from the viewpoint of productivity because the polysiloxane compound represented by Formula (1) is cured in a relatively short time.

When the polymerizable group is a radical polymerizable group such as a (meth)acryloyl group, a radical polymerization initiator is preferably used, and when the polymerizable group is a cationically polymerizable group such as an oxetanyl group and an epoxy group, a cationic polymerization initiator is preferably used.

The amount of the polymerization initiator included in the undercoat agent composition for layering an inorganic material layer of the present disclosure is preferably from 0.01 to 20 parts by weight, more preferably from 0.1 to 10 parts by weight, and still more preferably from 1 to 5 parts by weight, with respect to 100 parts by weight of the polysiloxane compound represented by Formula (1).

### 3-1. Active energy ray radical polymerization initiator

The active energy ray radical polymerization initiator used in the present disclosure is not particularly limited, and examples thereof include acetophenone compounds such as benzyl dimethyl ketal, 1-hydroxycyclohexylphenyl ketone, 2-hydroxy-2-methyl-1-phenylpropan-1-one, 1-[4-(2-hydroxyethoxy)phenyl]-2-hydroxy-2-methyl-1-propan-1-one, oligo[2-hydroxy-2-methyl-1-[4-1-(methylvinyl)phenyl]propanone, 2-hydroxy-1-{4-[4-(2-hydroxy-2-methyl-propionyl)benzyl]phenyl} -2-methylpropan-1 -one, 2-methyl-1-[4-(methylthio)]phenyl]-2-morpholinopropan-1-one, 2-benzyl-2-dimethylamino-1-(4-morpholinophenyl)butan-1-one, and 2-dimethylamino-2-(4-methylbenzyl)-1-(4-morpholin-4-yl-phenyl)butan-1-one; benzoin compounds such as benzoin, benzoin ethyl ether, benzoin isopropyl ether, and benzoin isobutyl ether; benzophenone compounds such as benzophenone, 2-methylbenzophenone, 3-methylbenzophenone, 4-methylbenzophenone, 2,4,6-trimethylbenzophenone, 4-phenylbenzophenone, methyl-2-benzophenone, 1-[4-(4-benzoylphenylsulfanyl)phenyl]-2-methyl-2-(4-methylphenylsulfonyl)propan-1-one, 4,4'-bis(dimethylamino)benzophenone, 4,4'-bis(diethylamino)benzophenone, and 4-methoxy-4'-dimethylaminobenzophenone; acylphosphine oxide compounds such as bis(2,4,6-trimethylbenzoyl)phenylphosphine oxide, 2,4,6-trimethylbenzoyldiphenylphosphine oxide, and bis(2,6-dimethoxybenzoyl)-2,4,4-trimethylpentylphosphine oxide; and thioxanthone compounds such as thioxanthone, 2-chlorothioxanthone, 2,4-diethylthioxanthone, isopropylthioxanthone, 1-chloro-4-propylthioxanthone, 3-[3,4-dimethyl-9-oxo-9H-thioxanthon-2-yl-oxy]-2-hydroxypropyl-N,N,N-trimethylammonium chloride, and fluorothioxanthone.

Examples of compounds other than the above include benzyl, ethyl (2,4,6-trimethylbenzoyl)phenylphosphinate, methyl phenylglyoxylate, ethylanthraquinone, phenanthrenequinone, and camphorquinone.

These may be used singly, or in combination of two or more.

### 3-2. Thermal radical polymerization initiator

The thermal radical polymerization initiator used in the present disclosure is not particularly limited, and examples thereof include peroxides and azo initiators.

Specific examples of peroxides include hydrogen peroxide; inorganic peroxides such as sodium persulfate, ammonium persulfate, and potassium persulfate; and organic peroxides such as 1,1-bis(t-butylperoxy) 2-methylcyclohexane, 1,1-bis(t-hexylperoxy)-3,3,5-trimethylcyclohexane, 1,1-bis(t-hexylperoxy)cyclohexane, 1,1-bis(t-butylperoxy)-3,3,5-trimethylcyclohexane, 1,1-bis(t-butylperoxy)cyclohexane, 2,2-bis(4,4-di-butylperoxycyclohexyl)propane, 1,1-bis(t-butylperoxy)cyclododecane, t-hexylperoxyisopropyl monocarbonate, t-butylperoxymaleic acid, t-butylperoxy-3,5,5-trimethylhexanoate, t-butylperoxylaurate, 2,5-dimethyl-2,5-di(m-toluoylperoxy)hexane, t-butylperoxy isopropyl monocarbonate, t-butylperoxy 2-ethylhexyl monocarbonate, t-hexyl peroxybenzoate, 2,5-dimethyl-2,5-di(benzoylperoxy)hexane, t-butylperoxyacetate, 2,2-bis(t-butylperoxy)butane, t-butylperoxybenzoate, n-butyl-4,4-bis(t-butylperoxy)valerate, di-t-butylperoxyisophthalate, α,α'-bis(t-butylperoxy)diisopropylbenzene, dicumyl peroxide, 2,5-dimethyl-2,5-di(t-butylperoxy)hexane, t-butylcumyl peroxide, di-t-butyl peroxide, p-menthane hydroperoxide, 2,5-dimethyl-2,5-di(t-butylperoxy)hexyne-3, diisopropylbenzene hydroperoxide, t-butyltrimethylsilyl peroxide, 1,1,3,3-tetramethylbutyl hydroperoxide, cumene hydroperoxide, t-hexyl hydroperoxide, and t-butyl hydroperoxide.

These may be used singly, or in combination of two or more.

Specific examples of azo initiators include azo compounds such as 2,2'-azobisisobutyronitrile, 1,1'-azobis(cyclohexane-1-carbonitrile), 2-(carbamoyl azo)isobutyronitrile, 2-phenylazo-4-methoxy-2,4-dimethylvaleronitrile, azo di-t-octane, and azo di-t-butane. These may be used singly, or in combination of two or more.

Also, a redox reaction is possible by combining with a redox polymerization initiation system using peroxides and reducing agents such as, ascorbic acid, sodium ascorbate, sodium erythorbate, tartaric acid, citric acid, metal salts of formaldehyde sulfoxylate, sodium thiosulfate, sodium sulfite, sodium bisulfite, sodium metabisulfite, and ferric chloride.

### 3-3. Active energy ray cationic polymerization initiator

The active energy ray cationic polymerization initiator used in the present disclosure is not particularly limited, and examples thereof include onium salts such as iodonium salts, sulfonium salts, diazonium salts, selenium salts, pyridinium salts, ferrocenium salts, and phosphonium salts. Among these, iodonium salts and sulfonium salts are preferred.

When the active energy ray cationic polymerization initiator is an iodonium salt or a sulfonium salt, examples of counter anions include BF₄⁻, AsF₆⁻, SbF₆⁻, PF₆⁻, and B(C₆F₅)₄⁻.

Examples of iodonium salts include (tricumyl)iodonium-tetrakis(pentafluorophenyl)borate, diphenyliodonium - hexafluorophosphate, diphenyliodonium - hexafluoroantimonate, diphenyliodonium - tetrafluoroborate, diphenyliodonium - tetrakis(pentafluorophenyl)borate, bis(dodecylphenyl)iodonium-hexafluorophosphate, bis(dodecylphenyl)iodonium - hexafluoroantimonate, bis(dodecylphenyl)iodonium - tetrafluoroborate, bis(dodecylphenyl)iodonium-tetrakis(pentafluorophenyl)borate, 4-methylphenyl-4-(1-methylethyl)phenyliodonium-hexafluorophosphate, 4-methylphenyl-4-(1-methylethyl)phenyliodonium-hexafluoroantimonate, 4-methylphenyl-4-(1-methylethyl)phenyliodonium - tetrafluoroborate, and 4-methylphenyl-4-(1-methylethyl)phenyliodonium - tetrakis(pentafluorophenyl)borate.

Commercially available iodonium salts can also be used, and specific examples thereof include "UV-9380C" (trade name) manufactured by GE Toshiba Silicone Co., Ltd., "RHODOSIL PHOTOINITIATOR 2074" (trade name) manufactured by Rhodia, and "WPI-116" (trade name) and "WPI-113" (trade name) manufactured by FUJIFILM Wako Pure Chemical Industries, Ltd..

These may be used singly, or in combination of two or more.

Examples of sulfonium salts include bis[4-(diphenylsulfonio)phenyl]sulfide-bishexafluorophosphate, bis[4-(diphenylsulfonio)phenyl]sulfide - bishexafluoroantimonate, bis[4-(diphenylsulfonio)phenyl]sulfide - bistetrafluoroborate, bis[4-(diphenylsulfonio)phenyl]sulfide - tetrakis(pentafluorophenyl)borate, diphenyl-4-(phenylthio)phenylsulfonium - hexafluorophosphate, diphenyl-4-(phenylthio)phenylsulfonium - hexafluoroantimonate, diphenyl-4-(phenylthio)phenylsulfonium - tetrafluoroborate, diphenyl-4-(phenylthio)phenylsulfonium-tetrakis(pentafluorophenyl)borate, triphenylsulfonium hexafluorophosphate, triphenylsulfonium - hexafluoroantimonate, triphenylsulfonium tetrafluoroborate, triphenylsulfonium - tetrakis(pentafluorophenyl)borate, bis[4-(di(4-(2-hydroxyethoxy))phenylsulfonio)phenyl]sulfide - bishexafluorophosphate, bis[4-(di(4-(2-hydroxyethoxy))phenylsulfonio)phenyl]sulfide - bishexafluoroantimonate, bis[4-(di(4-(2-hydroxyethoxy))phenylsulfonio)phenyl]sulfide - bistetrafluoroborate, and bis[4-(di(4-(2-hydroxyethoxy))phenylsulfonio)phenyl] sulfide - tetrakis(pentafluorophenyl)borate.

In addition, commercially available sulfonium salts can also be used, and specific examples thereof include "Cyracure UVI-6990" (trade name), "Cyracure UVI-6992" (trade name), and "Cyracure UVI-6974" manufactured by Dow Chemical Japan Co., Ltd., and "ADEKA OPTOMER SP-150" (trade name), "ADEKA OPTOMER SP-152" (trade name), "ADEKA OPTOMER SP-170" (trade name), and "ADEKA OPTOMER SP-172" (trade name) manufactured by ADEKA.

These may be used singly, or in combination of two or more.

Examples of diazonium salts include benzenediazonium hexafluoroantimonate, benzenediazonium hexafluorophosphate, and benzenediazonium hexafluoroborate. These may be used singly, or in combination of two or more.

### 3-4. Thermal cationic polymerization initiator

The thermal cationic polymerization initiator used in the present disclosure is not particularly limited, and examples thereof include sulfonium salts, phosphonium salts, and quaternary ammonium salts. Among these, sulfonium salts are preferred.

Examples of counter anions in the thermal cationic polymerization initiator include AsF₆⁻, SbF₆⁻, PF₆⁻, and B(C₆F₅)₄⁻.

Examples of sulfonium salts include triphenylsulfonium boron tetrafluoride, triphenylsulfonium antimony hexafluoride, triphenylsulfonium arsenic hexafluoride, tri(4-methoxyphenyl)sulfonium arsenic hexafluoride, and diphenyl(4-phenylthiophenyl)sulfonium arsenic hexafluoride.

Moreover, commercially available sulfonium salts can also be used, and specific examples thereof include "ADEKA OPTON CP-66" (trade name) and "ADEKA OPTON CP-77" (trade name) manufactured by ADEKA, and "San-Aid SI-60L" (trade name), "San-Aid SI-80L" (trade name), and "San-Aid SI-100L" (trade name) manufactured Sanshin Chemical by Kogyo Co., Ltd..

These may be used singly, or in combination of two or more.

Examples of phosphonium salts include ethyltriphenylphosphonium antimony hexafluoride, and tetrabutylphosphonium antimony hexafluoride.

Examples of quaternary ammonium salts include N,N-dimethyl-N-benzylanilinium antimony hexafluoride, N,N-diethyl-N-benzylanilinium boron tetrafluoride, N,N-dimethyl-N-benzyl pyridinium antimony hexafluoride, N,N-diethyl-N-benzylpyridinium trifluoromethanesulfonate, N,N-dimethyl-N-(4-methoxybenzyl)pyridinium antimony hexafluoride, N,N-diethyl-N-(4-methoxybenzyl)pyridinium antimony hexafluoride, N,N-diethyl-N-(4-methoxybenzyl)toluidinium antimony hexafluoride, and N,N-dimethyl-N-(4-methoxybenzyl)toluidinium antimony hexafluoride.

These may be used singly, or in combination of two or more.

### 4. Undercoat agent composition for layering inorganic material layer

The undercoat agent composition for layering an inorganic material layer of the present disclosure (hereinafter, also referred to as "composition of the present disclosure") includes the polysiloxane compound according to the present disclosure, and at least one of the radical polymerization initiator or the cationic polymerization initiator.

The polysiloxane compound according to the present disclosure has excellent fluidity and curability and, as described later, the inorganic material layer layered on a surface of the cured product by a dry film-forming method has excellent adhesiveness, and the cured product is excellent in at least one of heat resistance, scratch resistance, or hardness. Therefore, the composition of the present disclosure can be used as an undercoat agent that is applied on a resin substrate, for layering an inorganic material layer on the resin substrate by a dry film-forming method.

The composition of the present disclosure includes the polysiloxane compound, and at least one of the radical polymerization initiator or the cationic polymerization initiator, and various components (hereinafter, referred to as "other components") can be formulated therein as needed.

Other components are preferably a (meth)acrylate compound, a cationically polymerizable compound, and a compound having an ethylenically unsaturated group, each of which is a polymerizable compound that can be polymerized with the polysiloxane compound, a radical polymerization inhibitor, an antioxidant, a solvent, a heat resistance improver, silicone, and the like.

The other components are explained below.

### 4-1. (Meth)acrylate compound

The composition of the present disclosure includes the polysiloxane compound represented by Formula (1), in which a compound having an acryloyl group or a methacryloyl group (hereinafter, referred to as (meth)acrylate compound) or the like can be formulated for the purpose of adjusting the physical properties such as scratch resistance and hardness of a cured product formed from the composition of the present disclosure or adjusting the viscosity, curability, or the like of the composition of the present disclosure.

The (meth)acrylate compound is not particularly limited, and examples thereof include a compound having one (meth)acryloyl group (hereinafter, referred to as "monofunctional (meth)acrylate") and a compound having two or more (meth)acryloyl groups (hereinafter, referred to as "polyfunctional (meth)acrylate").

Examples of monofunctional (meth)acrylates include alkyl (meth)acrylates such as methyl (meth)acrylate, ethyl (meth)acrylate, butyl (meth)acrylate, and 2-ethylhexyl (meth)acrylate;
monofunctional (meth)acrylates having an alicyclic group such as cyclohexyl (meth)acrylate, tert-butylcyclohexyl (meth)acrylate, isobornyl (meth)acrylate, and tricyclodecanemethylol (meth)acrylate;
monofunctional (meth)acrylates having an aromatic group such as benzyl (meth)acrylate and phenyl (meth)acrylate;
(meth)acrylates of alkylene oxide adducts of phenol derivatives such as a (meth)acrylate of phenol ethylene oxide adduct, a (meth)acrylate of phenol propylene oxide adduct, a (meth)acrylate of modified nonylphenol ethylene oxide adduct, a (meth)acrylate of nonylphenol propylene oxide adduct, a (meth)acrylate of paracumylphenol alkylene oxide adduct, orthophenylphenol (meth)acrylate, and a (meth)acrylate of orthophenylphenol alkylene oxide adduct;
monofunctional (meth)acrylates having an alkoxyalkyl group such as 2-ethylhexylcarbitol (meth)acrylate;
monofunctional (meth)acrylates having a heterocyclic ring such as tetrahydrofurfuryl (meth)acrylate and N-(2-(meth)acryloxyethyl)hexahydrophthalimide;
hydroxyalkyl (meth)acrylates such as hydroxyethyl (meth)acrylate, hydroxypropyl (meth)acrylate, hydroxybutyl (meth)acrylate, and hydroxyhexyl (meth)acrylate;
monofunctional (meth)acrylates having a hydroxyl group and an aromatic group such as 2-hydroxy-3-phenoxypropyl (meth)acrylate;
alkylene glycol mono(meth)acrylates such as diethylene glycol mono(meth)acrylate, dipropylene glycol mono(meth)acrylate, triethylene glycol mono(meth)acrylate, and tripropylene glycol mono(meth)acrylate; and
monofunctional (meth)acrylates having a carboxyl group such as ω-carboxypolycaprolactone mono(meth)acrylate and monohydroxyethyl phthalate (meth)acrylate;

Examples of polyfunctional (meth)acrylates include diethylene glycol di(meth)acrylate, triethylene glycol di(meth)acrylate, tetraethylene glycol di(meth)acrylate, dipropylene glycol di(meth)acrylate, tripropylene glycol di(meth)acrylate, tetrapropylene glycol di(meth)acrylate, polypropylene glycol di(meth)acrylate, 1,4-butanediol di(meth)acrylate, neopentyl glycol di(meth)acrylate, di(meth)acrylate of ethylene oxide-modified neopentyl glycol, di(meth)acrylate of ethylene oxide-modified bisphenol A, di(meth)acrylate of propylene oxide-modified bisphenol A, di(meth)acrylate of ethylene oxide-modified hydrogenated bisphenol A, trimethylolpropane di(meth)acrylate, trimethylolpropane allyl ether di(meth)acrylate, trimethylolpropane tri(meth)acrylate, ethylene oxide-modified trimethylolpropane tri(meth)acrylate, propylene oxide-modified trimethylolpropane tri(meth)acrylate, pentaerythritol tri(meth)acrylate, pentaerythritol tetra(meth)acrylate, and dipentaerythritol hexaacrylate.

A urethane (meth)acrylate can also be used as the polyfunctional (meth)acrylate.

Examples of urethane (meth)acrylates include a compound obtained by addition reaction of an organic polyisocyanate and a hydroxyl group-containing (meth)acrylate, and a compound obtained by addition reaction of an organic polyisocyanate, a polyol, and a hydroxyl group-containing (meth)acrylate.

These may be used singly, or in combination of two or more, and different types may be used in combination.

Examples of polyols include low-molecular-weight polyols, polyether polyols, polyester polyols, and polycarbonate polyols.

Examples of low-molecular-weight polyols include ethylene glycol, propylene glycol, neopentyl glycol, cyclohexanedimethylol, and 3-methyl-1,5-pentanediol.

Examples of polyether polyols include polypropylene glycol and polytetramethylene glycol.

Examples of polyester polyols include reaction products of at least one of these low-molecular-weight polyols or polyether polyols with acid components such as dibasic acids such as adipic acid, succinic acid, phthalic acid, hexahydrophthalic acid, and terephthalic acid, or anhydrides thereof.

These may be used singly, or in combination of two or more, and different types may be used in combination.

Examples of organic polyisocyanates include tolylene diisocyanate, xylylene diisocyanate, tetramethylxylylene diisocyanate, 4,4'-diphenylmethane diisocyanate, 4,4'-dicyclohexylmethane diisocyanate, hexamethylene diisocyanate, and isophorone diisocyanate.

Examples of hydroxyl group-containing (meth)acrylates include hydroxyalkyl (meth)acrylates such as 2-hydroxyethyl (meth)acrylate, 2-hydroxypropyl (meth)acrylate, and 4-hydroxybutyl (meth)acrylate, and hydroxyl group-containing polyfunctional (meth)acrylates such as pentaerythritol tri(meth)acrylate, di(meth)acrylate of alkylene oxide 3-mol adduct of isocyanuric acid, and dipentaerythritol pentaacrylate. These may be used singly, or in combination of two or more, or different types may be used in combination.

When the (meth)acrylate compound is further included in the composition of the present disclosure, the formulation ratio is not particularly limited, but the formulation ratio of the (meth)acrylate compound with respect to 100 parts by weight of the polysiloxane compound represented by Formula (1) is preferably 100 parts by weight or less, more preferably 50 parts by weight or less, and still more preferably 20 parts by weight or less. From the viewpoint of adhesiveness to the inorganic material layer, the formulation ratio of the (meth)acrylate compound is preferably low, preferably 10% by weight or less, more preferably 5% by weight or less, and still more preferably 1% by weight or less.

### 4-2. Compound having ethylenically unsaturated group other than (meth)acrylate compound

In the composition of the present disclosure, a compound having one ethylenically unsaturated group within one molecule other than the (meth)acrylate compound may be formulated for the purpose of reducing the viscosity when used without a solvent, improving the adhesiveness to the adherend, etc.

The ethylenically unsaturated group is preferably a (meth)acryloyl group, a maleimide group, a (meth)acrylamide group, or a vinyl group.

Specific examples of the compound having an ethylenically unsaturated group include (meth)acrylic acid, a michael addition type dimer of acrylic acid, N-(2-hydroxyethyl)citraconimide, N,N-dimethylacrylamide, acryloylmorpholine, N-vinylpyrrolidone, and N-vinylcaprolactam.

These may be used singly, or in combination of two or more.

Further, when the compound having an ethylenically unsaturated group is included in the composition of the present disclosure, the formulation ratio of the compound having an ethylenically unsaturated group with respect to the total amount of the polysiloxane compound represented by Formula (1) is preferably 10% by weight or less, more preferably 5% by weight or less, and still more preferably 1% by weight or less, from the viewpoint of the adhesiveness and weather resistance of the inorganic material layer.

### 4-3. Cationically polymerizable compound

When the polysiloxane represented by Formula (1) is a polysiloxane having a monovalent organic group having an epoxy group or an oxetanyl group, the composition of the present disclosure preferably includes a cationically polymerizable compound other than the polysiloxane in order to increase the hardness of the cured product and the adhesiveness to the adherend.

The cationically polymerizable compound is a compound that is cationically polymerizable other than the polysiloxane compound represented by Formula (1), and examples thereof include epoxy compounds (compounds having an epoxy group), other compounds having an oxetanyl group (other oxetanyl group-containing compounds), and compounds having a vinyl ether group (vinyl ether compounds). These compounds may be used singly, or in combination of two or more.

When the polysiloxane compound represented by Formula (1) has at least an oxetanyl group, epoxy compounds are particularly preferred because of exhibiting the effect of facilitating cationic polymerization of the oxetanyl groups in the polysiloxane compound represented by Formula (1).

Examples of epoxy compounds include monofunctional epoxy compounds and polyfunctional epoxy compounds.

Examples of polyfunctional epoxy compounds include dicyclopentadiene dioxide, limonene dioxide, 4-vinylcyclohexene dioxide, (3,4-epoxycyclohexyl)methyl-3,4-epoxycyclohexyl carboxylate (for example, "Celoxide 2021P" (trade name) manufactured by Daicel Co., Ltd.), di(3,4-epoxycyclohexyl)adipate, bisphenol A type epoxy resin, halogenated bisphenol A type epoxy resin, hydrogenated bisphenol A type epoxy resin, bisphenol S diglycidyl ether, bisphenol F type epoxy resin, 1,6-hexanediol diglycidyl ether, polytetramethylene glycol diglycidyl ether, a compound in which both terminals of polybutadiene are glycidyl etherified, o-cresol novolak type epoxy resin, m-cresol novolak type epoxy resin , p-cresol novolak type epoxy resin, phenol novolak type epoxy resin, trimethylolpropane triglycidyl ether, pentaerythritol tetraglycidyl ether, internal epoxidized polybutadiene, a compound in which a double bond in a styrene-butadiene copolymer is partially epoxidized, such as "Epofriend" (trade name) manufactured by Daicel Co., Ltd., a compound in which an isoprene polymer portion in a block copolymer having an ethylenebutylene copolymer portion and the isoprene polymer portion is partially epoxidized, such as "L-207" (trade name) manufactured by KRATON Co., Ltd., a compound in which a vinyl group in a ring-opening polymer of 4-vinylcyclohexene oxide is epoxidized, such as "EHPE3150" (trade name) manufactured by Daicel Co., Ltd., a cage-shaped silsesquioxane having a glycidyl group, such as "Q-4" in the "Q8 series" manufactured by Mayaterials, an alicyclic-type cage-shaped silsesquioxane having an epoxy group, such as "Q-5" in the "Q8 series" manufactured by Mayaterials, an epoxy group-containing silsesquioxane compound, and an epoxidized vegetable oil.

From the viewpoint of weather resistance, the composition of the present disclosure more preferably includes a polyfunctional epoxy compound.

Examples of monofunctional epoxy compounds include α-olefin epoxides such as 1,2-epoxyhexadecane, phenyl glycidyl ether, 2-ethylhexyl glycidyl ether, dodecyl glycidyl ether, and glycidyl methacrylate.

Examples of other oxetanyl group-containing compounds include monofunctional oxetane compounds and polyfunctional oxetane compounds.

Examples of polyfunctional oxetane compounds include 1,4-bis{[(3-ethyl-3-oxetanyl)methoxy]methyl}benzene (XDO), di[2-(3-oxetanyl)butyl]ether (DOX), 1,4-bis[(3-ethyloxetan-3-yl)methoxy]benzene (HQOX), 1,3-bis[(3-ethyloxetan-3-yl)methoxy]benzene (RSOX), 1,2-bis[(3-ethyloxetan-3-yl)methoxy]benzene (CTOX), 4,4'-bis[(3-ethyloxetan-3-yl)methoxy]biphenyl (4,4'-BPOX), 2,2'-bis[(3-ethyl-3-oxetanyl)methoxy]biphenyl (2,2'-BPOX), 3,3',5,5'-tetramethyl[4,4'-bis(3-ethyloxetane-3-yl)methoxy]biphenyl (TM-BPOX), 2,7-bis[(3-ethyloxetane-3-yl)methoxy]naphthalene (2,7-NpDOX), 1,6-bis[(3-ethyloxetane-3-yl)methoxy]-2,2,3,3,4,4,5,5-octafluorohexane (OFH-DOX), 3(4),8(9)-bis[(1-ethyl-3-oxetanyl)methoxymethyl]-tricyclo[5.2.1.02.6]decane, 1,2-bis[2-[(1-ethyl-3-oxetanyl)methoxy]ethylthio]ethane, 4,4'-bis[(1-ethyl-3-oxetanyl)methyl]thiodibenzenethioether, 2,3-bis[(3-ethyloxetan-3-yl)methoxymethyl]norbornane (NDMOX), 2-ethyl-2-[(3-ethyloxetan-3-yl)methoxymethyl]-1,3-0-bis[(1-ethyl-3-oxetanyl)methyl]-propane-1,3-diol (TMPTOX), 2,2-dimethyl-1,3-0-bis[(3-ethyloxetan-3-yl)methyl]-propane-1,3-diol (NPGOX), 2-butyl-2-ethyl-1,3-0-bis[(3-ethyloxetan-3-yl)methyl]-propane-1,3-diol, 1,4-0-bis[(3-ethyloxetan-3-yl)methyl]-butane-1,4-diol, 2,4,6-0-tris[(3-ethyloxetan-3-yl)methyl]cyanuric acid, etherified product of bisphenol A and 3-ethyl-3-chloromethyloxetane (hereinafter, abbreviated as "OXC") (BisAOX), etherified product of bisphenol F and OXC (BisFOX), etherified product of phenol novolak and OXC (PNOX), etherified product of cresol novolak and OXC (CNOX), oxetanylsilsesquioxane (OX-SQ), and silicon alkoxide of 3-ethyl-3-hydroxymethyloxetane (OX-SC).

Further, examples of monofunctional oxetane compounds include 3-ethyl-3-(2-ethylhexyloxymethyl)oxetane (EHOX), 3-ethyl-3-(dodecyloxymethyl)oxetane (OXR-12), 3-ethyl-3-(octadecyloxymethyl)oxetane (OXR-18), 3-ethyl-3-(phenoxymethyl)oxetane (POX), and 3-ethyl-3-hydroxymethyloxetane (OXA).

Among these, dicyclopentadiene dioxide, limonene dioxide, 4-vinylcyclohexene dioxide, 3,4-epoxycyclohexylmethyl-3',4'-epoxycyclohexanecarboxylate, di(3,4-epoxycyclohexyl)adipate, and epoxy group-containing silsesquioxane compounds are preferred, and 3,4-epoxycyclohexylmethyl-3',4'-epoxycyclohexane carboxylate and the following epoxy group-containing silsesquioxane compounds are more preferred. From the viewpoint of improving the adhesiveness of the inorganic material layer, organic-inorganic hybrid compounds having an epoxy group, such as epoxy group-containing silsesquioxane compounds and epoxy group-containing silicone compounds, are particularly preferred.

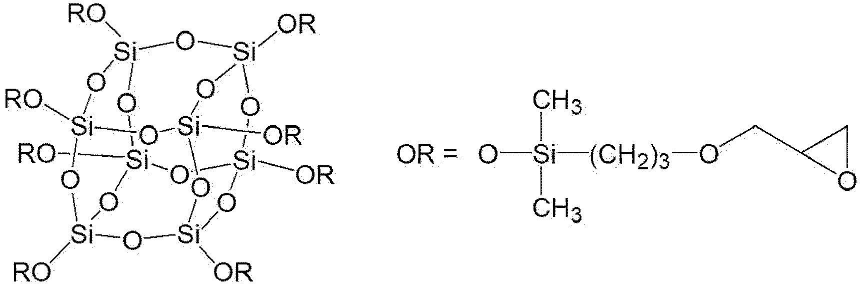

Examples of vinyl ether compounds include monofunctional vinyl ether compounds and polyfunctional vinyl ether compounds.

Examples of polyfunctional vinyl ether compounds include cyclohexanedimethanol divinyl ether, triethylene glycol divinyl ether, and novolak type divinyl ether.

Also, examples of monofunctional vinyl ether compounds include hydroxyethyl vinyl ether, hydroxybutyl vinyl ether, dodecyl vinyl ether, propenyl ether propylene carbonate, and cyclohexyl vinyl ether.

When the cationically curable composition of the present disclosure includes the cationically polymerizable compound, the content of the cationically polymerizable compound is not particularly limited, but is preferably from 0.1 to 100 parts by weight, more preferably from 0.1 to 50 parts by weight, and still more preferably from 1 to 25 parts by weight, with respect to 100 parts by weight of the polysiloxane compound represented by Formula (1). When the content of the cationically polymerizable compound is within this range, the curability of the composition of the present disclosure, the hardness of the resulting cured product, and the like are excellent.

Further, when the composition of the present disclosure includes the cationically polymerizable compound other than the polysiloxane compound represented by Formula (1), the content thereof is preferably 25% by weight or less, more preferably 10% by weight or less, and still more preferably 5% by weight or less, with respect to the total weight of the polysiloxane compound represented by Formula (1) from the viewpoint of the adhesiveness of the inorganic material layer.

### 4-4. Organic polymer

An organic polymer can be formulated in the composition of the present disclosure for the purpose of reducing the cure shrinkage rate by using inexpensive components, or the like.

Examples of suitable polymers include (meth)acrylic polymers, and examples of suitable constituent monomers include methyl methacrylate, cyclohexyl (meth)acrylate, and N-(2-(meth)acryloxyethyl)tetrahydrophthalimide.

Further, when the organic polymer is included in the composition of the present disclosure, the content thereof is preferably 10% by weight or less, more preferably 5% by weight or less, and still more preferably 1% by weight or less, with respect to the total weight of the polysiloxane compound represented by Formula (1), from the viewpoint of the adhesiveness and weather resistance of the inorganic material layer.

### 4-5. Radical polymerization inhibitor and antioxidant

A radical polymerization inhibitor or an antioxidant may be added to the composition of the present disclosure for the purpose of improving storage stability and thermal stability.

The polymerization inhibitor and antioxidant to be used are not particularly limited, and known radical scavengers can be used.

Specific examples of radical polymerization inhibitors include phenolic compounds such as hydroquinone and hydroquinone monomethyl ether.

Specific examples of antioxidants include hindered phenol antioxidants such as 2,6-di-tert-butyl-4-methylphenol, 2,4-dimethyl-6-tert-butylphenol, and pentaerythritol tetrakis(3-(3,5-di-tert-butyl-4-hydroxyphenyl)propionate), and 3-hydroxythiophenol. Also, examples thereof include α-nitroso-β-naphthol, p-benzoquinone, and copper salts. Furthermore, N-nitrosophenylhydroxylamine aluminum salt available from Fujifilm Wako Pure Chemical Industries, Ltd., and 2-[1-(2-hydroxy-3,5-di-tert-pentylphenyl)ethyl]-4,6-di-tert-pentylphenyl acrylate available from Sumitomo Chemical Co., Ltd., and the like can also be used. These may be used singly, or in combination of two or more.

In addition, a sulfur-based secondary antioxidant such as 4,6-bis(octylthiomethyl)-O-cresol or a phosphorus-based secondary antioxidant may be added in combination.

### 4-6. Solvent

When the composition of the present disclosure is liquid, the composition can be applied to a substrate surface as it is, but can also be used after being diluted with a solvent as necessary. When a solvent is used, a solvent that dissolves the polysiloxane compound according to the present disclosure is preferred, examples of which include various organic solvents such as aliphatic hydrocarbon solvents, aromatic hydrocarbon solvents, chlorinated hydrocarbon solvents, alcohol solvents, ether solvents, amide solvents, ketone solvents, ester solvents, and cellosolve solvents.

The organic solvent is not particularly limited, and examples thereof include alcohols such as methanol, ethanol, isopropyl alcohol, and isobutyl alcohol; alkylene glycol monoalkyl ethers such as propylene glycol monomethyl ether; aromatic compounds such as toluene and xylene; esters such as propylene glycol monomethyl ether acetate, ethyl acetate, and butyl acetate; ketones such as acetone, methyl ethyl ketone, and methyl isobutyl ketone; ethers such as dibutyl ether; and N-methylpyrrolidone. These may be used singly, or in combination of two or more.

When a solvent is used, it is preferable to volatilize the solvent included in the applied film prior to curing the composition of the present disclosure. Volatilization of the solvent may be performed in the air or in an inert gas atmosphere. Heating may be performed to volatilize the solvent, but the heating temperature in that case is preferably less than 100°C.

### 4-7. Heat resistance improver

The composition of the present disclosure can include a heat resistance improver.

The heat resistance improver is not particularly limited, and known heat resistance improvers can be used. Examples of heat resistance improvers include: organic carboxylic acid metal salts such as iron 2-ethylhexanoate such as tris(2-ethylhexanoate) iron (III), cerium 2-ethylhexanoate such as tris(2-ethylhexanoate) cerium (III), and zirconium 2-ethylhexanoate such as tetra(2-ethylhexanoate) zirconium (IV) and bis(2-ethylhexanoate) zirconium (IV) oxide; and metal oxides such as iron oxide, cerium oxide, and zirconium oxide.

The usage ratio of the heat resistance improver is not particularly limited, but is, for example, from 0 to 10,000 ppm by weight, from 1 to 1,000 ppm by weight, from 5 to 500 ppm by weight, or from 10 to 300 ppm by weight, with respect to 100 parts by weight of the total amount of the polysiloxane compound according to the present disclosure.

Addition of a heat resistance improver can suppress the increase or decrease in heat weight loss temperature, suppress the decrease in dielectric constant, suppress the decrease in insulation properties, suppress the occurrence of cracks, and suppress coloring during use and storage under heating and at room temperature.

### 4-8. Silicone

The composition of the present disclosure can include silicone.

The silicone is not particularly limited, and known silicones can be used. Examples thereof include polydimethylsilicone, polydiphenylsilicone, and polymethylphenylsilicone, each of which may have a functional group at at least one of its terminal or side chain. The functional group is not particularly limited, and examples thereof include a (meth)acryloyl group, an epoxy group, an oxetanyl group, a vinyl group, a hydroxyl group, a carboxyl group, an amino group, and a thiol group.

The usage ratio of the silicone is not particularly limited but, for example, is from 0 to 100 parts by weight, from 1 to 50 parts by weight, from 5 to 40 parts by weight, or from 5 to 30 parts by weight, with respect to 100 parts by weight of the total amount of the polysiloxane compound according to the present disclosure.

### 4-9. Other components other than the above

The composition of the present disclosure can optionally include components than those described above as other components.

Specifically, any other adjuvants such as surfactants, antistatic agents (for example, conductive polymers), leveling agents such as silicone polymers and fluorine atom-containing polymers, photosensitizers, UV absorbers, stabilizers, lubricants, pigments, dyes, plasticizers, suspending agents, nanoparticles, nanofibers, nanosheets, and various fillers such as silica and alumina can be contained. In addition, silane-based reactive diluents such as tetraalkoxysilanes, trialkoxysilanes, dialkoxysilanes, monoalkoxysilanes, and disiloxanes can also be contained.

### 5. Resin substrate

The resin substrate used for layering an inorganic material layer according to the present disclosure is not particularly limited, and examples thereof include: resins such as polyethylene resin, polypropylene resin, acrylonitrile-butadiene-styrene (ABS) resin, polyamide resin, acrylic resin, vinylidene chloride resin, polycarbonate resin (PC), polyurethane resin, epoxy resin, polyester resins such as polyethylene terephthalate (PET), polyethylene naphthalate (PEN), and polybutylene phthalate (PBT), polystyrene resin, polyvinyl chloride resin, polyacrylonitrile resin, polyimide resin, acrylic resin such as polyacrylate and polymethacrylate such as polymethyl methacrylate (PMMA), cycloolefin polymer (COP), cycloolefin copolymer (COC), acetate resin, vinyl fluoride resin, polyarylate, cellophane, polyether sulfone, norbornene-based resin, and acetylcellulose resin such as triacetylcellulose (TAC); and plastic materials such as various fiber reinforced resin (FRP).

In addition, as the resin substrate, a substrate having appropriate physical properties is preferable depending on the intended use. From the viewpoint of heat resistance, examples of physical properties include melting point, which is preferably 150°C or higher, and more preferably 200°C or higher. From the viewpoint of optical properties, examples of physical properties include turbidity (haze), birefringence, and refractive index. For example, the haze (ASTM D1003) is preferably 2% or less, and more preferably 0.5% or less. For example, the retardation (parallel Nicols rotation method) is preferably 30 or less, more preferably 20 or less, and still more preferably 5 or less. For example, the refractive index is preferably 1.48 or more.

For example, from the viewpoint of optical properties, polycarbonate resin and polymethyl methacrylate are preferred. From the viewpoint of gas barrier properties, polyethylene terephthalate is preferred.

Furthermore, as such a resin substrate, it is desirable to use a resin substrate having excellent applicability with the undercoat agent composition of the present disclosure and excellent adhesiveness with the cured product thereof. In order to further improve the adhesiveness of the cured product for layering an inorganic material layer of the present disclosure, for example, a resin substrate of which surface is subjected to surface activation treatment such as corona discharge treatment, ultraviolet irradiation treatment, and plasma treatment, can be used.

The shape of the resin substrate used in the present disclosure is not particularly limited, and may be arbitrarily selected according to the application, such as film, sheet, lens, or plate.

### 6. Inorganic material layer

The inorganic material layer in the present disclosure is not particularly limited as long as it is formed by a dry film-forming method, and examples thereof include a layer containing, as a main component, at least one of various metals or metal oxides, nitrides and sulfides containing elements such as Si, Ti, Zn, Al, Ga, In, Ce, Bi, Sb, B, Zr, Sn, Ta, Ag, and Pt.

Specific examples of materials that form the inorganic material layer include low refractive index materials such as sodium fluoride, cryolite, thiolite, lithium fluoride, magnesium fluoride, aluminum fluoride, calcium fluoride, strontium fluoride, zirconium fluoride, silicon dioxide, barium fluoride, and yttrium fluoride, medium refractive index materials such as OL-B, lanthanum fluoride, neodymium fluoride, gadolinium fluoride, cerium fluoride, aluminum oxide, tungsten oxide, magnesium oxide, lead fluoride, silicon monoxide, lanthanum oxide, yttrium oxide, scandium oxide, europium oxide, molybdenum oxide, samarium fluoride, and praseodymium oxide, high refractive index materials such as indium oxide, tin oxide, hafnium oxide, tantalum oxide, zirconium oxide, antimony oxide, zinc oxide, cerium oxide, OS-5, neodymium oxide, niobium oxide, zinc sulfide, dititanium trioxide, trititanium pentoxide, titanium monoxide , titanium dioxide, silicon, and germanium, metals such as silver, aluminum, gold, chromium, copper, hafnium, indium, molybdenum, nickel, platinum, tantalum, titanium, and tungsten, and other functional agents such as germanium oxide, ITO, MS-DC100, and MS-SY.

Also, examples of the layer include a diamond-like carbon (hereinafter, referred to as DLC) film layer with high hardness and excellent insulation. The DLC film is a carbon film with an amorphous structure mainly composed of sp³ bonds between carbon atoms, which is a diamond-like carbon film that is extremely hard, that has a low coefficient of friction, wear resistance, corrosion resistance, and gas barrier properties, and that has excellent insulating properties.

The inorganic material layer in the present disclosure may be at least one layer, or may be multiple layers. When the inorganic material layer is multiple layers, the order of layering them and the type of the respective inorganic material layer are not particularly limited. Moreover, various functional layers such as an ultraviolet absorption layer and a functional layer may be used as the inorganic material layer.

When one layer of the inorganic material layers is a DLC layer, it is preferable to layer the DLC layer as the outermost layer on the metal oxide layer, because of having the aforementioned performance.

The inorganic material layer is arbitrarily selected according to the application.

The method of layering the inorganic material layer in the present disclosure is not particularly limited as long as it is a dry film-forming method. Examples thereof include dry film-forming methods such as vacuum deposition such as resistance heating deposition, electron beam heating deposition, and high frequency induction heating deposition, physical vapor deposition methods (hereinafter, also referred to as "PVD" or physical vapor deposition method) such as molecular beam epitaxy method, ion beam deposition, ion plating, sputtering, and laser ablation, chemical vapor deposition methods (hereinafter, also referred to as "CVD" or chemical vapor deposition method) such as thermal CVD, plasma CVD, optical CVD, epitaxial CVD, atomic layer CVD, catCVD, and organometallic CVD, and physical vapor deposition method is preferable.

The dry film-forming method referred to herein is a treatment of a material surface using a vapor phase or a molten state, and is generally called a dry process.

The thickness of the inorganic material layer is not particularly limited, and can be arbitrarily set according to the purpose and application. The thickness is preferably 5 nm or more, more preferably 50 nm or more, still more preferably 100 nm or more, and even more preferably 150 nm or more, from the viewpoint of scratch resistance of the inorganic material layer. The upper limit of the thickness of the inorganic material layer is not particularly limited, but is preferably 25 µm or less, more preferably 15 µm or less, and still more preferably 10 µm or less. In order to adjust the thickness of the inorganic material layer, the process time and the like may be adjusted in the physical vapor deposition.

Since the inorganic material layer layered as described above is an inorganic material, the layered body according to the present disclosure has excellent appearance, weather resistance, and scratch resistance not found in organic coating films, is excellent in adhesiveness to the cured product for layering an inorganic material layer, and is extremely excellent in weather resistance, water resistance, and scratch resistance.

### 8. Undercoat agent composition for layering inorganic material layer and method of producing cured product thereof

The curable composition of the present disclosure can be obtained by mixing the raw material components. For mixing, a known mixer or the like may be used. Specific examples include reaction flasks, change can type mixers, planetary mixers, dispersers, Henschel mixers, kneaders, ink rolls, extruders, three-roll mills, and sand mills.

After the composition of the present disclosure is applied to an appropriate resin substrate, the composition of the present disclosure is usually cured by allowing the reaction of the polymerizable group to proceed by a method of irradiating an active energy ray, a method of heating, a method of combining active energy ray irradiation and heating, or the like.

The composition of the present disclosure may include or may not include a solvent and, when the composition includes a solvent, it is usually subjected to curing after removing the solvent as described above.

### 8-1. Curable composition

The composition of the present disclosure includes the polysiloxane compound represented by Formula (1) and at least one of the radical polymerization initiator or the cationic polymerization initiator. Furthermore, the aforementioned other components may also be included. When a solvent is included as other component, the solvent is usually removed by drying before the composition of the present disclosure is cured, followed by obtaining a cured product to form an undercoat. Therefore, in the composition of the present disclosure, the ratio of the polysiloxane compound represented by Formula (1) with respect to all components except for the solvent is preferably 50 parts by weight or more, more preferably 70 parts by weight or more, and still more preferably 90 parts by weight or more. A cured product having favorable adhesiveness to the inorganic material layer can be obtained by setting the ratio within the aforementioned preferable range.

When a solvent is mixed, the usage amount thereof is arbitrarily set according to the purpose and is not particularly limited. For example, the usage amount can be from 1 to 20,000 parts by weight, more preferably from 10 to 1,000 parts by weight, and still more preferably from 50 to 500 parts by weight, with respect to 100 parts by weight of the polysiloxane compound represented by Formula (1).

### 8-2. Application method

The method of applying the composition of the present disclosure to a resin substrate is not particularly limited, and is appropriately selected according to the constituent material, shape, etc. of the substrate. For example, ordinary coating methods such as casting, spin coating, bar coating, dip coating, spray coating, roll coating, flow coating, and gravure coating can be used.

The thickness of the composition of the present disclosure that is applied is not particularly limited and can be arbitrarily set according to the purpose. The thickness is preferably from 0.1 to 100 µm, more preferably from 0.5 to 50 µm, and still more preferably from 1 to 10 µm.

### 8-3. Curing method

In the present disclosure, the curing method and curing conditions are selected depending on whether the curable composition is active energy ray-curable, or thermosetting, or active energy ray-curable and thermosetting. In addition, curing conditions (in the case of active energy ray curing, the type of light source, the amount of light irradiation, and the like, and in the case of thermosetting, heating temperature, heating time, and the like) are appropriately selected depending on the type and amount of the polymerization initiator included in the composition of the present disclosure, the type of other polymerizable compound included in the composition of the present disclosure, and the like.

### (1) Active energy ray curing method

When the composition of the present disclosure is an active energy ray-curable composition, as a curing method, active energy ray irradiation may be performed with a known active energy ray irradiation device or the like. Examples of active energy rays include electron beams and light such as ultraviolet rays, visible rays, and X-rays. Light is preferable, and ultraviolet rays are more preferable because inexpensive devices can be used.

Examples of ultraviolet irradiation devices include low-pressure mercury lamps, medium-pressure mercury lamps, high-pressure mercury lamps, ultra-high-pressure mercury lamps, metal halide lamps, ultraviolet (UV) electrodeless lamps, chemical lamps, black light lamps, microwave-excited mercury lamps, and light-emitting diodes (LEDs).

The intensity of light irradiation to the film applied with the composition of the present disclosure may be selected according to the purpose, application, etc. The intensity of light irradiation in a light wavelength range effective for activation (depending on the type of photopolymerization initiator, light with a wavelength of from 220 to 460 nm is preferably used) of the active energy ray polymerization initiator (in the case of photocuring, the initiator is referred to as a photopolymerization initiator) is preferably from 0.1 to 1000 mW/cm².

In addition, the irradiation energy should be appropriately set according to the type of the active energy ray and the formulation composition. The light irradiation time to the coating film may also be selected according to the purpose, application, etc. The light irradiation time is preferably set such that the integrated amount of light, which is expressed as the product of the light irradiation intensity in the aforementioned light wavelength region and the light irradiation time, is from 10 to 7,000 mJ/cm². The integrated amount of light is preferably from 200 to 5,000 mJ/cm², and more preferably from 500 to 3,500 mJ/cm². When the integrated amount of light is within the aforementioned range, curing of the composition proceeds smoothly, and a uniform cured product can be easily obtained.

Also, heat curing can be appropriately combined before photocuring, or after photocuring, or before and after photocuring.

For example, a two-stage curing can be performed by, after impregnating the composition of the present disclosure into a substrate having a portion that becomes shaded when irradiated with light, first irradiating with light to cure the composition of the present disclosure in the area exposed to the light, followed by applying heat to cure the composition of the present disclosure in the area not exposed to the light. Such a substrate is not particularly limited, and examples thereof include substrates having complex shapes such as cloth-like, fibrous, powdery, porous, and uneven shapes, and two or more of these shapes may be combined.

### (2) Thermal curing method

When the composition of the present disclosure is a thermosetting composition, the curing method and curing conditions are not particularly limited.

The curing temperature is preferably from 80°C to 200°C, more preferably from 100°C to 180°C, and still more preferably from 110°C to 150°C. Moreover, the curing temperature may be constant or may be increased. Furthermore, temperature increase and temperature decrease may be combined.

The curing time is appropriately selected depending on the type of the thermal polymerization initiator, the content ratio of other components, etc., but is preferably from 10 to 360 minutes, more preferably from 30 to 300 minutes, and still more preferably from 60 to 240 minutes. By curing the coating film under the aforementioned preferable conditions, a uniform cured film free from blisters, cracks, or the like can be formed.

### 8-4. Physical property of cured product

The cured product obtained by curing the composition of the present disclosure (herein, simply referred to as "cured product of the present disclosure") has excellent adhesiveness to the resin substrate and adhesiveness to the inorganic material layer. The index of adhesiveness is not particularly limited and a known index is applied, and examples thereof include evaluation indexes such as a cross-cut peeling test (cross-cut method). When employing a cross-cut peeling test, the adhesiveness of the inorganic material layer of the layered body can be evaluated according to JIS K5600-5-6 (ISO-2409).

In addition, the cured product of the present disclosure has excellent hardness. The index of hardness is not particularly limited and a known index is applied, and examples thereof include evaluation indexes such as a pencil hardness test and a scratch resistance test (scratch test).

In addition, the cured product of the present disclosure is excellent in transparency, coloring resistance, ultraviolet resistance, flexibility, resin substrate followability, weather resistance, chemical resistance, scratch resistance, durability, and heat resistance.

Since the cured product of the present disclosure is obtained by curing the composition including the polysiloxane compound represented by Formula (1) as a main component and the polysiloxane compound according to the present disclosure includes a T unit and preferably further includes at least one of a D unit or an M unit, the SiO content in the cured product, that is, the content of inorganic components included in the cured product is high. Therefore, the cured product of the present disclosure has excellent adhesiveness to the inorganic material layer that is layered thereon. The cured product of the present disclosure including at least one of a D unit or an M unit is preferable because the cured product is superior in flexibility or resin substrate followability. In addition, the cured product of the present disclosure including at least one of a D unit or an M unit is preferable because the cured product is superior in surface smoothness.

By appropriately balancing the ratio of each constituent component of the polysiloxane according to the present disclosure, particularly the composition ratio of the constituent unit (b) and the constituent unit (c), according to the purpose and application, the cured product of the present disclosure obtained by curing the polysiloxane compound according to the present disclosure can exhibit well-balanced physical properties such as adhesiveness to the resin substrate, adhesiveness to the inorganic material layer, hardness, flexibility, and resin substrate followability.

### 9. Layered body

The layered body of the present disclosure includes the aforementioned cured product of the present disclosure, the resin substrate, and the inorganic material layer. The layered body of the present disclosure preferably includes at least one resin substrate, a cured product for layering an inorganic material layer that is obtained by curing the undercoat agent composition for layering an inorganic material layer of the present disclosure layered thereon, and at least one inorganic material layer layered on. The configuration is not particularly limited, and can be arbitrarily selected according to the purpose, application, and the like. For example, when the resin substrate is a film, a configuration is possible in which the cured product of the present disclosure and the inorganic material layer are sequentially layered at one side of the film, or a configuration is possible in which the cured product of the present disclosure and the inorganic material layer are sequentially layered at both sides of the film.

### 10. Application

The application of the layered body of the present disclosure is not particularly limited, and examples thereof include outer panel parts of automobile bodies such as passenger cars, trucks, motorcycles, and buses; automobile parts; and outer panel parts of home electric appliances such as mobile phones and audio equipment. Among them, outer panel parts of automobile bodies and automobile parts are preferable.

Further, it can be used for portions or parts that require moisture resistance in various devices such as optical elements, display devices (liquid crystal displays, organic EL displays, etc.), semiconductor devices, and thin film solar cells, packaging materials for packaging food, clothing, electronic components, or the like.

Furthermore, it can also be used for a decorative printed film layered body that is useful as a decorative film for display substrates, touch panels, films with transparent electrodes, lens sheets, optical waveguides, solar cell substrates, optical discs, various transparent substrates, or the like.

The functions of the inorganic material layer or the layered body are not particularly limited, and examples thereof include antireflection, antifogging, gas barrier, hard coat, scratch resistance, abrasion resistance, design, antistatic, conductivity, moisture resistance, weather resistance, light resistance, waterproof, oil resistance, antifouling, antibacterial, antivirus, antibiotic activity, UV resistance, resistance to cosmic rays, resistance to oxygen plasma, and resistance to atomic oxygen.

### Examples

Next, the present disclosure will be specifically described based on Examples and Comparative Examples, but the present disclosure is not limited to the following Examples.

The weight average molecular weight (hereinafter, also referred to as Mw) was determined by performing separation by gel permeation chromatography (hereinafter, referred to as "GPC") using coupled GPC columns "TSK gel G4000HX" and "TSK gel G2000HX" (manufactured by Tosoh Corporation) in an isopropyl alcohol solvent at 40°C, and by calculation from the retention time using standard polystyrene.

Also, the molar ratio of each constituent unit of the obtained polysiloxane compound was determined by dissolving the sample in deuterated chloroform and performing ¹H-NMR analysis and, if necessary, also performing ²⁹Si-NMR analysis. The alkoxysilane monomer was quantitatively reacted and introduced into the polysiloxane compound, but the introduction rate of the M unit derived from the disiloxane monomer was not quantitatively introduced depending on the composition of the polysiloxane compound.

The viscosity was measured using a cone plate at 25°C using TVE22H manufactured by Toki Sangyo Co., Ltd..

### [Synthesis of polysiloxane compound]

### <Synthesis Example 1>

A hydrolysis/polycondensation reaction was allowed to proceed according to a known method using (3-acryloyloxypropyl)trimethoxysilane, which is a T monomer, as a raw material silane monomer, isopropyl alcohol as a reaction solvent, and hydrochloric acid as a catalyst, followed by removing the solvent and the like to obtain Polysiloxane Compound 1 as a colorless transparent liquid. The composition ratio, Mw, and viscosity (25°C) of Polysiloxane Compound 1 are shown in Table 1.

### <Synthesis Example 2>

A hydrolysis/polycondensation reaction was allowed to proceed according to a known method using (3-acryloyloxypropyl)trimethoxysilane, which is a T monomer, and a both-terminated silanol-type polydimethylsiloxane, which is a D monomer, each as a raw material silane monomer, isopropyl alcohol as a reaction solvent, and tetramethylammonium hydroxide as a catalyst, followed by removing the solvent and the like to obtain Polysiloxane Compound 2 as a colorless transparent liquid. The composition ratio, Mw, and viscosity (25°C) of Polysiloxane Compound 2 are shown in Table 1.

### <Synthesis Example 3 to 7>

A hydrolysis/polycondensation reaction was allowed to proceed according to a known method using (3-acryloyloxypropyl)trimethoxysilane, which is a T monomer, and dimethoxydimethylsilane, which is a D monomer, each as a raw material silane monomer, isopropyl alcohol as a reaction solvent, and hydrochloric acid as a catalyst, followed by removing the solvent and the like to obtain Polysiloxane Compound 3 to Polysiloxane Compound 7 as colorless transparent liquids, respectively. The molar ratio of each constituent unit of the polysiloxane compound produced was the same as the charge ratio of each raw material monomer. The composition ratio, Mw, and viscosity (25°C) of each polysiloxane compound are shown in Table 1.

### <Synthesis Example 8>

A hydrolysis/polycondensation reaction was allowed to proceed according to a known method using (3-acryloyloxypropyl)trimethoxysilane, which is a T monomer, and 1,1,3,3-tetramethyl-1,3-divinyldisiloxane, which is an M monomer, each as a raw material silane monomer, isopropyl alcohol as a reaction solvent, and hydrochloric acid as a catalyst, followed by removing the solvent and the like to obtain Polysiloxane Compound 8 as a colorless transparent liquid. 1,1,3,3-Tetramethyl-1,3-divinyldisiloxane was quantitatively reacted and introduced into Polysiloxane Compound 8. The composition ratio, Mw, and viscosity (25°C) of Polysiloxane Compound 8 are shown in Table 1.

### <Synthesis Example 9>

A hydrolysis/polycondensation reaction was allowed to proceed according to a known method using (3-methacryloyloxypropyl)trimethoxysilane, which is a T monomer, as a raw material silane monomer, isopropyl alcohol as a reaction solvent, and hydrochloric acid as a catalyst, followed by removing the solvent and the like to obtain Polysiloxane Compound 9 as a colorless transparent liquid. The composition ratio, Mw, and viscosity (25°C) of Polysiloxane Compound 9 are shown in Table 1.

### <Synthesis Example 10>

A hydrolysis/polycondensation reaction was allowed to proceed according to a known method using (3-methacryloyloxypropyl)trimethoxysilane, which is a T monomer, and a both-terminated silanol-type polydimethylsiloxane, which is a D monomer, each as a raw material silane monomer, isopropyl alcohol as a reaction solvent, and tetramethylammonium hydroxide as a catalyst, followed by removing the solvent and the like to obtain Polysiloxane Compound 10 as a colorless transparent liquid. The composition ratio, Mw, and viscosity (25°C) of Polysiloxane Compound 10 are shown in Table 1.

### <Synthesis Example 11>

A hydrolysis/polycondensation reaction was allowed to proceed according to a known method using (3-methacryloyloxypropyl)trimethoxysilane, which is a T monomer, and dimethoxydimethylsilane, which is a D monomer, each as a raw material silane monomer, isopropyl alcohol as a reaction solvent, and hydrochloric acid as a catalyst, followed by removing the solvent and the like to obtain Polysiloxane Compound 11 as a colorless transparent liquid. The composition ratio, Mw, and viscosity (25°C) of Polysiloxane Compound 11 are shown in Table 1.

### <Synthesis Example 12>

A hydrolysis/polycondensation reaction was allowed to proceed according to a known method using 3-ethyl-3-[{3-(trimethoxysilyl)propoxy}methyl]oxetane, which is a T monomer, as a raw material silane monomer, isopropyl alcohol as a reaction solvent, and tetramethylammonium hydroxide as a catalyst, followed by removing the solvent and the like to obtain Polysiloxane Compound 12 as a colorless transparent liquid. The composition ratio, Mw, and viscosity (25°C) of Polysiloxane Compound 12 are shown in Table 1.

### <Synthesis Example 13>

A hydrolysis/polycondensation reaction was allowed to proceed according to a known method using 3-ethyl-3-[{3-(trimethoxysilyl)propoxy}methyl]oxetane, which is a T monomer, a both-terminated silanol-type polydimethylsiloxane, which is a D monomer, each as a raw material silane monomer, isopropyl alcohol as a reaction solvent, and tetramethylammonium hydroxide as a catalyst, followed by removing the solvent and the like to obtain Polysiloxane Compound 13 as a colorless transparent liquid. The composition ratio, Mw, and viscosity (25°C) of Polysiloxane Compound 13 are shown in Table 1.

### <Synthesis Example 14>

A hydrolysis/polycondensation reaction was allowed to proceed according to a known method using tetramethoxysilane, which is a Q monomer, and (3-methacryloyloxypropyl)trimethoxysilane, which is a T monomer, each as a raw material silane monomer, 1-propanol as a reaction solvent, and tetramethylammonium hydroxide as a catalyst, followed by neutralizing the reaction solution, extracting the product, and removing the solvent and the like to obtain Polysiloxane Compound 14 as a colorless solid. The composition ratio and Mw of Polysiloxane Compound 14 are shown in Table 1. Since the compound was solid, the viscosity was not measured.

The composition, molar ratio of each constituent unit, Mw, and viscosity (25°C) of the polysiloxane compound obtained in each of Synthesis Example 1 to Synthesis Example 14 are summarized in Table 1.

**[Table 1]**

| Synthesis example | Q unit Constituent unit (a) | T unit Constituent unit (b) | | | D unit Constituent unit (c) | M unit Constituent unit (d) | v/ (v+w+x+y) | w/ (v+w+x+y) | x/ (v+w+x+y) | y/ (v+w+x+y) | Mw | Viscosity mPa•s (25°C) |
|---|---|---|---|---|---|---|---|---|---|---|---|---|
| | | Si-AC | Si-MAC | Si-OX | SiMe2 | SiMe2Vi | | | | | | |
| 1 | - | 1 | - | - | - | - | 0 | 1 | 0 | 0 | 2330 | 5990 |
| 2 | - | 0.64 | - | - | 0.36 | - | 0 | 0.64 | 0.36 | 0 | 4800 | 2920 |
| 3 | - | 0.90 | - | - | 0.10 | - | 0 | 0.90 | 0.10 | 0 | 1200 | 1350 |
| 4 | - | 0.80 | - | - | 0.20 | - | 0 | 0.80 | 0.20 | 0 | 1160 | 1080 |
| 5 | - | 0.64 | - | - | 0.36 | - | 0 | 0.64 | 0.36 | 0 | 1970 | 550 |
| 6 | - | 0.51 | - | - | 0.49 | - | 0 | 0.51 | 0.49 | 0 | 1740 | 500 |
| 7 | - | 0.31 | - | - | 0.69 | - | 0 | 0.31 | 0.69 | 0 | 1440 | 190 |
| 8 | - | 0.72 | - | - | - | 0.28 | 0 | 0.72 | 0 | 0.28 | 1250 | 390 |
| 9 | - | - | 1 | - | - | - | 0 | 1 | 0 | 0 | 1840 | 3370 |
| 10 | - | - | 0.62 | - | 0.38 | - | 0 | 0.62 | 0.38 | 0 | 5290 | 1430 |
| 11 | - | - | 0.62 | - | 0.38 | - | 0 | 0.62 | 0.38 | 0 | 1680 | 1250 |
| 12 | - | - | - | 1 | - | - | 0 | 1 | 0 | 0 | 2300 | 30000 |
| 13 | - | - | - | 0.59 | 0.41 | - | 0 | 0.59 | 0.41 | 0 | 1900 | 4400 |
| 14 | 0.50 | - | 0.50 | - | - | - | 0.50 | 0.50 | 0 | 0 | 19200 | - |

| | | | | | | | | | | | | |
|---|---|---|---|---|---|---|---|---|---|---|---|---|
| AC: 3-acryloyloxypropyl group MAC: 3-methacryloyloxypropyl group OX: 3-[(3-ethyloxetan-3-yl)methoxy]propyl group Me: methyl group Vi: vinyl group | | | | | | | | | | | | |

### <Reference Example 1>

Aronix M-405 (dipentaerythritol penta- and hexaacrylate) manufactured by Toagosei Co., Ltd. was used as it was.

### <Example 1>

### (1) Preparation of photocurable undercoat agent composition

10 g of Polysiloxane Compound 1 obtained in Synthesis Example 1, 0.3 g of 1-hydroxycyclohexylphenyl ketone (Omnirad 184 manufactured by IGM RESINS B.V., hereinafter, also referred to as Om184) as a photoradical polymerization initiator, and 10 g of propylene glycol monobutyl ether acetate (hereinafter, also referred to as PGB) as a solvent were each weighed in a 50 mL vial, and stirred and dissolved with a rotation/revolution mixer to prepare a photocurable undercoat agent composition.

### (2) Application on resin substrate and photocuring

The photocurable composition prepared in (1) above was applied to a polycarbonate (hereinafter, also referred to as PC) plate (Iupilon NF-2000, thickness 1 mm, manufactured by Mitsubishi Gas Chemical Co., Ltd.) as a resin substrate using a bar coater to form a coating film having a thickness of about 5 µm, followed by drying the solvent by heating at 65°C for 5 minutes. Then, ultraviolet irradiation was performed under the following conditions to prepare a cured product.

### [Ultraviolet irradiation conditions]

Lamp: 80 W/cm high pressure mercury lamp
Lamp height: 10 cm
Conveyor speed: 5.7 m/min
Light irradiation intensity: 700 mW/cm²
Accumulated amount of light per pass: 360 mJ/cm²
Atmosphere: in the air
Number of passes: 9 times

### (3) Layering inorganic material layer

On the photocured product prepared in (2) above, platinum was layered by sputtering using the following equipment and conditions. The thickness of the platinum layer was about 10 nm.

### [Platinum sputtering conditions]

MSP-1S manufactured by Vacuum Device Co., Ltd., Magnetron Sputter Discharge Current: 30 mA, Process Time: 20sec.

### (4) Adhesiveness test of inorganic material layer: adhesiveness (cross-cut method)

Adhesiveness was evaluated according to JIS K5600-5-6 (ISO-2409) for the inorganic material layer of the layered body produced by (1) to (3) above. Adhesiveness was evaluated by the number of peeled squares out of 25 squares, and the smaller the number of peeled squares is, the higher the adhesiveness is. In Example 1, two squares were peeled off.

In this evaluation, no peeling between the resin substrate and the photocured product of the undercoating agent composition was found.

The results of this example are summarized in Table 2.

### <Example 2>

A layered body was prepared in the same manner as in Example 1, except that a polymethyl methacrylate (hereinafter, also referred to as PMMA) plate (Acrylite L, manufactured by Mitsubishi Chemical Corporation, thickness of 1 mm) was used instead of polycarbonate as the resin substrate, and the adhesiveness of the inorganic material layer was evaluated. The results are shown in Table 2.

### <Example 3>

A layered body was prepared in the same manner as in Example 1, except that SiO₂ was layered by ion plating method instead of platinum as the inorganic material layer, and the adhesiveness of the inorganic material layer was evaluated. The thickness of the SiO₂ layer was about 200 nm. The results are shown in Table 2.

### <Example 4>

A layered body was prepared in the same manner as in Example 1, except that ZrO₂ was layered by ion plating method instead of platinum as the inorganic material layer, and the adhesiveness of the inorganic material layer was evaluated. The thickness of the ZrO₂ layer was about 200 nm. The results are shown in Table 2.

### <Example 5>

A layered body was prepared in the same manner as in Example 1, except that Polysiloxane Compound 2 obtained in Synthesis Example 2 was used instead of Polysiloxane Compound 1 obtained in Synthesis Example 1, and the adhesiveness of the inorganic material layer was evaluated. The results are shown in Table 2.

### <Example 6>

A layered body was prepared in the same manner as in Example 4, except that Polysiloxane Compound 2 obtained in Synthesis Example 2 was used instead of Polysiloxane Compound 1 obtained in Synthesis Example 1, and the adhesiveness of the inorganic material layer was evaluated. The results are shown in Table 2.

### <Example 7>

A layered body was prepared in the same manner as in Example 3, except that Polysiloxane Compound 2 obtained in Synthesis Example 2 was used instead of Polysiloxane Compound 1 obtained in Synthesis Example 1, and the adhesiveness of the inorganic material layer was evaluated. The results are shown in Table 2.

### <Example 8>

A layered body was prepared in the same manner as in Example 1, except that Polysiloxane Compound 3 obtained in Synthesis Example 3 was used instead of Polysiloxane Compound 1 obtained in Synthesis Example 1, and the adhesiveness of the inorganic material layer was evaluated. The results are shown in Table 2.

### <Example 9>

A layered body was prepared in the same manner as in Example 1, except that Polysiloxane Compound 4 obtained in Synthesis Example 4 was used instead of Polysiloxane Compound 1 obtained in Synthesis Example 1, and the adhesiveness of the inorganic material layer was evaluated. The results are shown in Table 2.

### <Example 10>

A layered body was prepared in the same manner as in Example 1, except that Polysiloxane Compound 5 obtained in Synthesis Example 5 was used instead of Polysiloxane Compound 1 obtained in Synthesis Example 1, and the adhesiveness of the inorganic material layer was evaluated. The results are shown in Table 2.

### <Example 11>

A layered body was prepared in the same manner as in Example 10, except that a polyethylene terephthalate (hereinafter, also referred to as PET) plate (manufactured by Takiron C.I. Co., Ltd., thickness of 1 mm) was used instead of polycarbonate as the resin substrate, and the adhesiveness of the inorganic material layer was evaluated. The results are shown in Table 2.

### <Example 12>

A layered body was prepared in the same manner as in Example 10, except that a nylon 6 (hereinafter, also referred to as Nylon 6) plate (manufactured by TP Giken Co., Ltd., thickness of 1 mm) was used instead of polycarbonate as the resin substrate, and the adhesiveness of the inorganic material layer was evaluated. The results are shown in Table 2.

### <Example 13>

A layered body was prepared in the same manner as in Example 3, except that Polysiloxane Compound 5 obtained in Synthesis Example 5 was used instead of Polysiloxane Compound 1 obtained in Synthesis Example 1, and the adhesiveness of the inorganic material layer was evaluated. The results are shown in Table 2.

### <Example 14>

A layered body was prepared in the same manner as in Example 4, except that Polysiloxane Compound 5 obtained in Synthesis Example 5 was used instead of Polysiloxane Compound 1 obtained in Synthesis Example 1, and the adhesiveness of the inorganic material layer was evaluated. The results are shown in Table 2.

### <Example 15>

A layered body was prepared in the same manner as in Example 1, except that Polysiloxane Compound 6 obtained in Synthesis Example 6 was used instead of Polysiloxane Compound 1 obtained in Synthesis Example 1, and the adhesiveness of the inorganic material layer was evaluated. The results are shown in Table 2.

### <Example 16>

A layered body was prepared in the same manner as in Example 1, except that Polysiloxane Compound 7 obtained in Synthesis Example 7 was used instead of Polysiloxane Compound 1 obtained in Synthesis Example 1, and the adhesiveness of the inorganic material layer was evaluated. The results are shown in Table 2.

### <Example 17>

A layered body was prepared in the same manner as in Example 1, except that Polysiloxane Compound 8 obtained in Synthesis Example 8 was used instead of Polysiloxane Compound 1 obtained in Synthesis Example 1, and the adhesiveness of the inorganic material layer was evaluated. The results are shown in Table 2.

### <Example 18>

A layered body was prepared in the same manner as in Example 1, except that Polysiloxane Compound 9 obtained in Synthesis Example 9 was used instead of Polysiloxane Compound 1 obtained in Synthesis Example 1, and the adhesiveness of the inorganic material layer was evaluated. The results are shown in Table 2.

### <Example 19>

A layered body was prepared in the same manner as in Example 18, except that polymethyl methacrylate was used instead of polycarbonate as the resin substrate, and the adhesiveness of the inorganic material layer was evaluated. The results are shown in Table 2.

### <Example 20>

A layered body was prepared in the same manner as in Example 4, except that Polysiloxane Compound 9 obtained in Synthesis Example 9 was used instead of Polysiloxane Compound 1 obtained in Synthesis Example 1, and the adhesiveness of the inorganic material layer was evaluated. The results are shown in Table 2.

### <Example21>

A layered body was prepared in the same manner as in Example 1, except that Polysiloxane Compound 10 obtained in Synthesis Example 10 was used instead of Polysiloxane Compound 1 obtained in Synthesis Example 1, and the adhesiveness of the inorganic material layer was evaluated. The results are shown in Table 2.

### <Example 22>

A layered body was prepared in the same manner as in Example 3, except that Polysiloxane Compound 10 obtained in Synthesis Example 10 was used instead of Polysiloxane Compound 1 obtained in Synthesis Example 1, and the adhesiveness of the inorganic material layer was evaluated. The results are shown in Table 2.

### <Example 23>

A layered body was prepared in the same manner as in Example 4, except that Polysiloxane Compound 10 obtained in Synthesis Example 10 was used instead of Polysiloxane Compound 1 obtained in Synthesis Example 1, and the adhesiveness of the inorganic material layer was evaluated. The results are shown in Table 2.

### <Example 24>

A layered body was prepared in the same manner as in Example 1, except that Polysiloxane Compound 11 obtained in Synthesis Example 11 was used instead of Polysiloxane Compound 1 obtained in Synthesis Example 1, and the adhesiveness of the inorganic material layer was evaluated. The results are shown in Table 2.

### <Example 25>

A layered body was prepared in the same manner as in Example 24, except that polyethylene terephthalate was used instead of polycarbonate as the resin substrate, and the adhesiveness of the inorganic material layer was evaluated. The results are shown in Table 2.

### <Example 26>

A layered body was prepared in the same manner as in Example 24, except that nylon 6 was used instead of polycarbonate as the resin substrate, and the adhesiveness of the inorganic material layer was evaluated. The results are shown in Table 2.

### <Example 27>

A layered body was prepared in the same manner as in Example 3, except that Polysiloxane Compound 11 obtained in Synthesis Example 11 was used instead of Polysiloxane Compound 1 obtained in Synthesis Example 1, and the adhesiveness of the inorganic material layer was evaluated. The results are shown in Table 2.

### <Example 28>

A layered body was prepared in the same manner as in Example 4, except that Polysiloxane Compound 11 obtained in Synthesis Example 11 was used instead of Polysiloxane Compound 1 obtained in Synthesis Example 1, and the adhesiveness of the inorganic material layer was evaluated. The results are shown in Table 2.

### <Example 29>

9 g of Polysiloxane Compound 12 obtained in Synthesis Example 12, 1g of Celoxide 2021P (3',4'-epoxycyclohexylmethyl 3,4-epoxycyclohexanecarboxylate, hereinafter, also referred to as CEL2021P) manufactured by Daicel Corporation, 0.2 g of PHOTO INITIATOR 2074 (manufactured by Solvay Japan Co., Ltd., hereinafter, also referred to as PI2074) as a photo cationic polymerization initiator, and 10 g of PGB as a solvent were each weighed into a 50 mL vial, and dissolved by stirring with a rotation/revolution mixer to prepare a photocurable undercoat agent composition.

A layered body was prepared using this composition in the same manner as in (2) to (4) of Example 1, and the adhesiveness of the inorganic material layer was evaluated. The results are shown in Table 2.

### <Example 30>

A layered body was prepared in the same manner as in Example 29, except that Polysiloxane Compound 13 obtained in Synthesis Example 13 was used instead of Polysiloxane Compound 12 obtained in Synthesis Example 12, and the adhesiveness of the inorganic material layer was evaluated. The results are shown in Table 2.

### <Example31>

A layered body was prepared in the same manner as in Example 3, except that Polysiloxane Compound 9 obtained in Synthesis Example 9 was used instead of Polysiloxane Compound 1 obtained in Synthesis Example 1, and the adhesiveness of the inorganic material layer was evaluated. The results are shown in Table 2.

### <Example 32>

A layered body was prepared in the same manner as in Example 29, except that SiO₂ was layered by ion plating method instead of platinum as the inorganic material layer, and the adhesiveness of the inorganic material layer was evaluated. The results are shown in Table 2.

### <Example 33>

A layered body was prepared in the same manner as in Example 3, except that Polysiloxane Compound 14 obtained in Synthesis Example 14 was used instead of Polysiloxane Compound 1 obtained in Synthesis Example 1, and the adhesiveness of the inorganic material layer was evaluated. The results are shown in Table 2.

### <Example 34>

### (1) Preparation of thermosetting undercoat agent composition

10 g of Polysiloxane Compound 11 obtained in Synthesis Example 11, 0.1 g of t-butyl 2-ethylperoxyhexanoate (Perbutyl O manufactured by NOF Corporation, hereinafter, also referred to as PBO) as a thermal radical polymerization initiator, and 10 g of PGB as a solvent were each weighed into 50 mL vial, and dissolved by stirring with a rotation/revolution mixer to prepare a thermosetting undercoat agent composition.

### (2) Application on resin substrate and heat curing

The thermosetting composition prepared in (1) above was applied on a polycarbonate (hereinafter, also referred to as PC) plate (manufactured by Mitsubishi Gas Chemical Co., Ltd., Iupilon NF-2000, thickness of 1 mm) as a resin substrate using a bar coater, to form a film having a thickness of about 5 µm, and the solvent was then dried by heating at 65°C for 5 minutes. Then, heating was performed at 120°C for 1 hour in a constant temperature machine to prepare a cured product.

### (3) Layering inorganic material layer

ZrO₂ was layered on the thermoset product prepared in (2) above by ion plating method.

### (4) Adhesiveness test of inorganic material layer: adhesiveness (cross-cut method)

Adhesiveness was evaluated according to JIS K5600-5-6 (ISO-2409) for the inorganic material layer of the layered body produced by (1) to (3) above. Adhesiveness was evaluated by the number of peeled squares out of 25 squares, and the smaller the number of peeled squares is, the higher the adhesiveness is. In Example 34, there were no peeled squares, i.e., the number of peeled squares was 0 squares.

In this evaluation, no peeling between the resin substrate and the thermoset product of the undercoat agent composition was found.

The results of this example are summarized in Table 2.

### <Example 35>

9 g of Polysiloxane Compound 13 obtained in Synthesis Example 13, 1 g of CEL2021P, 0.1 g of San-Aid SI-100L (manufactured by Sanshin Chemical Industry Co., Ltd., hereinafter, also referred to as SI100L) as a thermal cationic polymerization initiator, and 10 g of PGB as a solvent were each weighed into a 50 mL vial, and dissolved by stirring with a rotation/revolution mixer to prepare a thermosetting undercoat agent composition.

A layered body was prepared in the same manner as in (2) to (4) of Example 34, except that this composition was used and the inorganic material layer was changed to SiO₂, and the adhesiveness of the inorganic material layer was evaluated. The results are shown in Table 2.

### <Comparative Example 1>

A layered body was prepared in the same manner as in Example 1, except that M-405 described in Reference Example 1 was used instead of Polysiloxane Compound 1 obtained in Synthesis Example 1, and the adhesiveness of the inorganic material layer was evaluated. The results are shown in Table 2.

### <Comparative Examples 2 to 4>

A layered body was prepared in the same manner as in Comparative Example 1, except that polymethyl methacrylate, polyethylene terephthalate, or nylon 6 was used instead of polycarbonate as the resin substrate, and the adhesiveness of each inorganic material layer was evaluated. The results are shown in Table 2.

### <Comparative Example 5>

A layered body was prepared in the same manner as in Example 3, except that M-405 described in Reference Example 1 was used instead of Polysiloxane Compound 1 obtained in Synthesis Example 1, and the adhesiveness of the inorganic material layer was evaluated. The results are shown in Table 2.

### <Comparative Example 6>

A layered body was prepared in the same manner as in Example 4, except that M-405 described in Reference Example 1 was used instead of Polysiloxane Compound 1 obtained in Synthesis Example 1, and the adhesiveness of the inorganic material layer was evaluated. The results are shown in Table 2.

### <Comparative Examples 7 to 10>

A layered body was prepared in the same manner as in Example 1, except that polycarbonate, polymethyl methacrylate, polyethylene terephthalate, or nylon 6 was used as the resin substrate, and an undercoat layer for layering an inorganic material layer was not provided, and the adhesiveness of each inorganic material layer was evaluated. The results are shown in Table 2.

### <Comparative Example 11>

A layered body was prepared in the same manner as in Example 3, except that an undercoat layer for layering an inorganic material was not provided, and the adhesiveness of the inorganic material layer was evaluated. The results are shown in Table 2.

### <Comparative Example 12>

A layered body was prepared in the same manner as in Example 4, except that an undercoat layer for layering an inorganic material was not provided, and the adhesiveness of the inorganic material layer was evaluated. The results are shown in Table 2.

### (5) Adhesiveness test of inorganic material layer after hot water treatment: adhesiveness (cross-cut method)

### <Examples 36 to 41>

The layered body prepared as in each of Examples 3, 31, 22, 27, 32, and 33 was immersed in hot water at 90°C for 2 hours, and then dried at room temperature for 17 hours. Thereafter (hereinafter, also referred to as "after hot water treatment"), the adhesiveness of each inorganic material layer was evaluated in the same manner as in (4) of Example 1. The results are shown in Table 3.

### <Comparative Examples 13 and 14>

The layered body prepared as in each of Comparative Examples 5 and 1 1was immersed in hot water at 90°C for 2 hours, and then dried at room temperature for 17 hours. Thereafter, the adhesiveness of each inorganic material layer was evaluated in the same manner as in (4) of Example 1. The results are shown in Table 3.

### (6) Scratch resistance test of inorganic material layer: scratch test

### <Example 42>

For the inorganic material layer of the layered body prepared as in Example 3 using Polysiloxane Compound 1, PC as the resin substrate, and SiO₂ as the inorganic material layer, a scratch test was performed under the following conditions to measure a critical load value, to evaluate the scratch resistance of the inorganic material layer.

Apparatus used; micro scratch tester (CSR-5000), manufactured by Resca Co., Ltd.
Stylus (tip needle) diameter: 25 µm
Scratch speed: 10 µm/sec
Amplitude: 100 µm
Load applied: 10 mN/sec

As a result, the critical load value was 42.1 mN. The results are shown in Table 4. The higher this value, the higher the scratch resistance.

### <Examples 43 to 56>

A layered body was prepared in the same manner as in Example 42, except that Polysiloxane Compound 1, 5, 9, or 11 was used, PC, PMMA, or PET was used as the resin substrate, and SiO₂ or ZrO₂ was used as the inorganic material layer, and the scratch resistance of each inorganic material layer was evaluated. The results are shown in Table 4.

### <Example 57>

A cured product for layering an inorganic material was formed on PC as in Example 29 using Polysiloxane Compound 12 and PC as the resin substrate, and SiO₂ was then layered by ion plating method. For the prepared layered body, the scratch resistance of the inorganic material layer was evaluated in the same manner as in Example 42. As a result, the critical load value was 51.1 mN. The results are shown in Table 4.

### <Example 58>

The scratch resistance of the inorganic material layer was evaluated for the prepared layered body in the same manner as in Example 57, except that Polysiloxane Compound 13 was used. The result was a critical load value of 69.3 mN. The results are shown in Table 4.

### <Example 59>

A cured product for layering an inorganic material was formed on PC as in Example 34 using Polysiloxane Compound 11 and PC as the resin substrate, and ZrO₂ was then layered by ion plating method. For the prepared layered body, the scratch resistance of the inorganic material layer was evaluated in the same manner as in Example 42. As a result, the critical load value was 63.9 mN. The results are shown in Table 4.

### <Example 60>

A cured product for layering an inorganic material was formed on PC as in Example 35 using Polysiloxane Compound 13 and PC as the resin substrate, and SiO₂ was then layered by ion plating method. For the prepared layered body, the scratch resistance of the inorganic material layer was evaluated in the same manner as in Example 42. As a result, the critical load value was 68.7 mN. The results are shown in Table 4.

### <Comparative Examples 15 to 19>

A layered body in which PC, PMMA, or PET was used as the resin substrate and SiO₂ or ZrO₂ was used as the inorganic material layer was prepared in the same manner as in Comparative Example 5 or 6, except that M-405 described in Reference Example 1 was used instead of the polysiloxane compound and PMMA or PET was used as the resin substrate, and the scratch resistance of each inorganic material layer was evaluated in the same manner as in Example 42. The results are shown in Table 4.

### <Comparative Examples 20 to 24>

The scratch resistance of each inorganic material layer was evaluated in the same manner as in Comparative Examples 15 to 19, except that M-405 described in Reference Example 1 was not used. The results are shown in Table 4.

**[Table 2]**

| | Undercoat agent composition for layering inorganic material | | | | | | Resin substrate | Inorganic material layer | Adhesiveness test |
|---|---|---|---|---|---|---|---|---|---|
| | Polysiloxane compound | | | Polymerizable compound | Polymerization initiator | Solvent | | | Number of peeled squares out of 25 squares |
| | | Polymerizable group | Constituent unit | | | | | | |
| Example 1 | Polysiloxane compound 1 | AC | T | - | Om 184 | PGB | PC | Pt | 2 |
| Example 2 | Polysiloxane compound 1 | AC | T | - | Om 184 | PGB | PMMA | Pt | 3 |
| Example 3 | Polysiloxane compound 1 | AC | T | - | Om184 | PGB | PC | SiO₂ | 5 |
| Example 4 | Polysiloxane compound 1 | AC | T | - | Om 184 | PGB | PC | ZrO₂ | 4 |
| Example 5 | Polysiloxane compound 2 | AC | T, D | - | Om184 | PGB | PC | Pt | 0 |
| Example 6 | Polysiloxane compound 2 | AC | T, D | - | Om 184 | PGB | PC | SiO₂ | 1 |
| Example 7 | Polysiloxane compound 2 | AC | T, D | - | Om 184 | PGB | PC | ZrO₂ | 0 |
| Example 8 | Polysiloxane compound 3 | AC | T, D | - | Om184 | PGB | PC | Pt | 1 |
| Example 9 | Polysiloxane compound 4 | AC | T, D | - | Om184 | PGB | PC | Pt | 1 |
| Example 10 | Polysiloxane compound 5 | AC | T, D | - | Om184 | PGB | PC | Pt | 1 |
| Example 11 | Polysiloxane compound 5 | AC | T, D | - | Om 184 | PGB | PET | Pt | 0 |
| Example 12 | Polysiloxane compound 5 | AC | T, D | - | Om 184 | PGB | Nylon6 | Pt | 1 |
| Example 13 | Polysiloxane compound 5 | AC | T, D | - | Om 184 | PGB | PC | SiO₂ | 1 |
| Example 14 | Polysiloxane compound 5 | AC | T, D | - | Om 184 | PGB | PC | ZrO₂ | 0 |
| Example 15 | Polysiloxane compound 6 | AC | T, D | - | Om184 | PGB | PC | Pt | 1 |
| Example 16 | Polysiloxane compound 7 | AC | T, D | - | Om184 | PGB | PC | Pt | 3 |
| Example 17 | Polysiloxane compound 8 | AC | T, M | - | Om 184 | PGB | PC | Pt | 2 |
| Example 18 | Polysiloxane compound 9 | MAC | T | - | Om 184 | PGB | PC | Pt | 4 |
| Example 19 | Polysiloxane compound 9 | MAC | T | - | Om 184 | PGB | PMMA | Pt | 3 |
| Example 20 | Polysiloxane compound 9 | MAC | T | - | Om 184 | PGB | PC | ZrO₂ | 4 |
| Example 21 | Polysiloxane compound 10 | MAC | T, D | - | Om184 | PGB | PC | Pt | 0 |
| Example 22 | Polysiloxane compound 10 | MAC | T, D | - | Om184 | PGB | PC | SiO₂ | 0 |
| Example 23 | Polysiloxane compound 10 | MAC | T, D | - | Om 184 | PGB | PC | ZrO₂ | 0 |
| Example 24 | Polysiloxane compound 11 | MAC | T, D | - | Om184 | PGB | PC | Pt | 0 |
| Example 25 | Polysiloxane compound 11 | MAC | T, D | - | Om 184 | PGB | PET | Pt | 1 |
| Example 26 | Polysiloxane compound 11 | MAC | T, D | - | Om 184 | PGB | Nylon6 | Pt | 2 |
| Example 27 | Polysiloxane compound 11 | MAC | T, D | - | Om184 | PGB | PC | SiO₂ | 1 |
| Example 28 | Polysiloxane compound 11 | MAC | T, D | - | Om 184 | PGB | PC | ZrO₂ | 0 |
| Example 29 | Polysiloxane compound 12 | OX | T | CEL2021P | PI2074 | PGB | PC | Pt | 2 |
| Example 30 | Polysiloxane compound 13 | OX | T, D | CEL2021P | PI2074 | PGB | PC | Pt | 0 |
| Example 31 | Polysiloxane compound 9 | MAC | T | - | Om 184 | PGB | PC | SiO₂ | 5 |
| Example 32 | Polysiloxane compound 12 | OX | T | CEL2021P | PI2074 | PGB | PC | SiO₂ | 2 |
| Example 33 | Polysiloxane compound 14 | MAC | Q, T | - | Om 184 | PGB | PC | SiO₂ | 5 |
| Example 34 | Polysiloxane compound 11 | MAC | T, D | - | PBO | PGB | PC | ZrO₂ | 0 |
| Example 35 | Polysiloxane compound 13 | OX | T, D | CEL2021P | SI100L | PGB | PC | SiO₂ | 0 |
| Comparative example 1 | - | - | - | M-405 | Om 184 | PGB | PC | Pt | 11 |
| Comparative example 2 | - | - | - | M-405 | Om 184 | PGB | PMMA | Pt | 6 |
| Comparative example 3 | - | - | - | M-405 | Om 184 | PGB | PET | Pt | 11 |
| Comparative example 4 | - | - | - | M-405 | Om 184 | PGB | Nylon6 | Pt | 6 |
| Comparative example 5 | - | - | - | M-405 | Om 184 | PGB | PC | SiO₂ | 12 |
| Comparative example 6 | - | - | - | M-405 | Om 184 | PGB | PC | ZrO₂ | 7 |
| Comparative example 7 | - | - | - | - | - | - | PC | Pt | 14 |
| Comparative example 8 | - | - | - | - | - | - | PMMA | Pt | 9 |
| Comparative example 9 | - | - | - | - | - | - | PET | Pt | 14 |
| Comparative example 10 | - | - | - | - | - | - | Nylon6 | Pt | 13 |
| Comparative example 11 | - | - | - | - | - | - | PC | SiO₂ | 17 |
| Comparative example 12 | - | - | - | - | - | - | PC | ZrO₂ | 10 |

**[Table 3]**

| | | Undercoat agent composition for layering inorganic material | | | | | | Resin substrate | Inorganic material layer | Adhesiveness test | |
|---|---|---|---|---|---|---|---|---|---|---|---|
| | | Polysiloxane compound | | | Polymerizable compound | Polymerization initiator | Solvent | | | Number of peeled squares out of 25 squares | |
| | Correspondence in Table 2 | | Polymerizable group | Constituent unit | | | | | | before hot water treatment | after hot water treatment |
| Example 36 | Example 3 | Polysiloxane compound 1 | AC | T | - | Om184 | PGB | PC | SiO₂ | 5 | 4 |
| Example 37 | Example 31 | Polysiloxane compound 9 | MAC | T | - | Om184 | PGB | PC | SiO₂ | 5 | 5 |
| Example 38 | Example 22 | Polysiloxane compound 10 | MAC | T, D | - | Om184 | PGB | PC | SiO₂ | 0 | 0 |
| Example 39 | Example 27 | Polysiloxane compound 11 | MAC | T, D | - | Om184 | PGB | PC | SiO₂ | 1 | 1 |
| Example 40 | Example 32 | Polysiloxane compound 12 | OX | T | CEL2021P | PI2074 | PGB | PC | SiO₂ | 2 | 0 |
| Example 41 | Example 33 | Polysiloxane compound 14 | MAC | Q, T | - | Om184 | PGB | PC | SiO₂ | 5 | 5 |
| Comparative example 13 | Comparative Example 5 | - | - | - | M-405 | Om184 | PGB | PC | SiO₂ | 12 | 25 |
| Comparative example 14 | Comparative Example 11 | - | - | - | - | - | - | PC | SiO₂ | 17 | 25 |

**[Table 4]**

| | Undercoat agent composition for layering inorganic material | | | | | | Resin substrate | Inorganic material layer | Scratch resistance |
|---|---|---|---|---|---|---|---|---|---|
| | Polysiloxane compound | | | Polymerizable compound | Polymerization initiator | Solvent | | | Critical load value mN |
| | | Polymerizable group | Constituent unit | | | | | | |
| Example 42 | Polysiloxane compound 1 | AC | T | - | Om 184 | PGB | PC | SiO₂ | 42.1 |
| Example 43 | Polysiloxane compound 1 | AC | T | - | Om 184 | PGB | PMMA | SiO₂ | 95.2 |
| Example 44 | Polysiloxane compound 1 | AC | T | - | Om 184 | PGB | PET | SiO₂ | 59.2 |
| Example 45 | Polysiloxane compound 5 | AC | T, D | - | Om 184 | PGB | PC | SiO₂ | 62.3 |
| Example 46 | Polysiloxane compound 5 | AC | T, D | - | Om 184 | PGB | PMMA | SiO₂ | 138.8 |
| Example 47 | Polysiloxane compound 5 | AC | T, D | - | Om184 | PGB | PET | SiO₂ | 88.9 |
| Example 48 | Polysiloxane compound 5 | AC | T, D | - | Om 184 | PGB | PMMA | ZrO₂ | 114.1 |
| Example 49 | Polysiloxane compound 9 | MAC | T | - | Om 184 | PGB | PC | SiO₂ | 49.4 |
| Example 50 | Polysiloxane compound 9 | MAC | T | - | Om 184 | PGB | PMMA | SiO₂ | 134.6 |
| Example 51 | Polysiloxane compound 9 | MAC | T | - | Om 184 | PGB | PET | SiO₂ | 78.3 |
| Example 52 | Polysiloxane compound 11 | MAC | T, D | - | Om184 | PGB | PC | SiO₂ | 71.1 |
| Example 53 | Polysiloxane compound 11 | MAC | T, D | - | Om 184 | PGB | PMMA | SiO₂ | 146.4 |
| Example 54 | Polysiloxane compound 11 | MAC | T, D | - | Om184 | PGB | PET | SiO₂ | 81.5 |
| Example 55 | Polysiloxane compound 11 | MAC | T, D | - | Om 184 | PGB | PC | ZrO₂ | 64.1 |
| Example 56 | Polysiloxane compound 11 | MAC | T, D | - | Om 184 | PGB | PMMA | ZrO₂ | 132.1 |
| Example 57 | Polysiloxane compound 12 | OX | T | CEL2021P | PI2074 | PGB | PC | SiO₂ | 51.1 |
| Example 58 | Polysiloxane compound 13 | OX | T, D | CEL2021P | PI2074 | PGB | PC | SiO₂ | 69.3 |
| Example 59 | Polysiloxane compound 11 | MAC | T, D | - | PBO | PGB | PC | ZrO₂ | 63.9 |
| Example 60 | Polysiloxane compound 13 | OX | T, D | CEL2021P | SI100L | PGB | PC | SiO₂ | 68.7 |
| Comparative example 15 | - | - | - | M-405 | Om 184 | PGB | PC | SiO₂ | 95.6 |
| Comparative example 16 | - | - | - | M-405 | Om184 | PGB | PMMA | SiO₂ | 152.2 |
| Comparative example 17 | - | - | - | M-405 | Om 184 | PGB | PET | SiO₂ | 64.4 |
| Comparative Example 18 | - | - | - | M-405 | Om 184 | PGB | PC | ZrO₂ | 56.0 |
| Comparative example 19 | - | - | - | M-405 | Om 184 | PGB | PMMA | ZrO₂ | 299.0 |
| Comparative example 20 | - | - | - | - | - | - | PC | SiO₂ | 18.4 |
| Comparative example 21 | - | - | - | - | - | - | PMMA | SiO₂ | 43.5 |
| Comparative example 22 | - | - | - | - | - | - | PET | SiO₂ | 16.9 |
| Comparative example 23 | - | - | - | - | - | - | PC | ZrO₂ | 50.8 |
| Comparative example 24 | - | - | - | - | - | - | PMMA | ZrO₂ | 80.5 |

As is clear from Table 2, the undercoat for layering an inorganic material layer of the present disclosure each has favorable adhesiveness to the resin substrate and the inorganic material layer. The adhesiveness (0 to 5) with the inorganic material layer of Examples 1 to 35 is excellent to various resin substrates and various inorganic material layers, compared with the adhesiveness (6 to 12) of Comparative Examples 1 to 6, each of which uses an undercoat including no polysiloxane, and the adhesiveness (9 to 17) of Comparative Examples 7 to 12, each of which uses no undercoat.

Further, from Table 2, it is understood that an undercoat including a polysiloxane compound having a T unit and a D unit as constituent units is superior in terms of adhesiveness to an inorganic material layer to an undercoat including a polysiloxane compound consisting of a T unit. This can be understood more clearly by comparing the cases where all conditions other than the polysiloxane compound are the same, for example, comparing Examples 1, 3, and 4 with Examples 5 to 10 and 13 to 15, comparing Examples 18 and 20 with Example 21, 23, and 24, or comparing Example 29 with Example 30.

The adhesiveness to the inorganic material layer of Example 16 was also "3", which is excellent, but the adhesiveness is slightly inferior to those having other T units and D units. Therefore, it is understood that the value of x/(v+w+x+y), which is the ratio of D unit, is preferably less than 0.69 of Polysiloxane Compound 7 contained in Example 16.

As is clear from Table 3, the undercoat for layering an inorganic material layer of the present disclosure has favorable adhesiveness to the resin substrate and the inorganic material layer even after hot water treatment. The adhesiveness (0 to 5) with the inorganic material layer of Examples 36 to 41 is superior in terms of adhesiveness after hot water treatment to the adhesiveness (25) of Comparative Example 13, which uses an undercoat including no polysiloxane, and the adhesiveness (25) of Comparative Example 14, which uses no undercoat.

As is clear from Tables 2 to 4, the undercoat for layering an inorganic material layer of the present disclosure can have both favorable adhesiveness to the resin substrate and the inorganic material layer and scratch resistance of the inorganic material layer of the layered body, so it is highly practical. This is clear, for example, from the result of Example 42, which is a layered body similar to Example 3 in Table 2, and the results of Examples 43 to 60, each of which is a modification example thereof. On the other hand, Comparative Examples 15 to 19 in Table 4 are each obtained by curing a curable composition that includes a polyfunctional monomer and includes no polysiloxane compound, and the scratch resistance may be high, but the adhesiveness to the inorganic material layer is insufficient, so it is not practical. This is clear, for example, from the results of Comparative Examples 15 and 18, which are layered bodies similar to Comparative Examples 5 and 6 in Table 2, respectively.

Further, it is understood from Table 4 that an undercoat including a polysiloxane compound having a T unit and a D unit as constituent units is superior in terms of scratch resistance of an inorganic material layer that is layered thereon to an undercoat including a polysiloxane compound consisting of a T unit. This can be understood more clearly by comparing the cases where all conditions other than the polysiloxane compound are the same, for example, comparing Examples 42 to 44 with Examples 45 to 47, comparing Examples 49 to 51 with Examples 52 to 54, or comparing Example 57 with Example 58.

Therefore, an undercoat including a polysiloxane compound having a T unit and a D unit as constituent units is particularly excellent in both physical properties of adhesiveness to an inorganic material layer and scratch resistance of a layered inorganic material layer, so it is more highly practical.

### Industrial Applicability

Examples of applications of the layered body of the present disclosure include outer panel parts of automobile bodies such as passenger cars, trucks, motorcycles, and buses; automobile parts; outer panel parts of home electric appliances such as mobile phones and audio equipment.

In addition, it can be used for portions or parts that require moisture resistance in various devices such as optical elements, display devices (liquid crystal displays, organic EL displays, etc.), semiconductor devices, and thin film solar cells, packaging materials for packaging food, clothing, electronic components, or the like.

Furthermore, it can also be used for a decorative printed film layered body that is useful as a decorative film for display substrates, touch panels, films with transparent electrodes, lens sheets, optical waveguides, solar cell substrates, optical discs, various transparent substrates, or the like.

Examples of the functions of the inorganic material layer or the layered body include antireflection, antifogging, gas barrier, hard coat, scratch resistance, abrasion resistance, design, antistatic, conductivity, moisture resistance, weather resistance, light resistance, waterproof, oil resistance, antifouling, antibacterial, antivirus, antibiotic activity, UV resistance, resistance to cosmic rays, resistance to oxygen plasma, and resistance to atomic oxygen.

The disclosure of Japanese Patent Application No. 2021-017829 filed February 5, 2021 is incorporated herein by reference in its entirety.

All publications, patent applications, and technical standards mentioned in this specification are herein incorporated by reference to the same extent as if each individual publication, patent application, or technical standard was specifically and individually indicated to be incorporated by reference.

## Claims

1. An undercoat agent composition for layering an inorganic material layer, the composition being applied on a resin substrate, for layering an inorganic material layer on the resin substrate by a dry film-forming method, the composition comprising a polysiloxane compound represented by Formula (1) below, and at least one of a radical polymerization initiator or a cationic polymerization initiator: 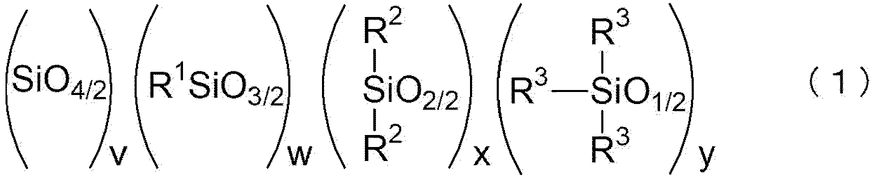 wherein, in Formula (1), each of R¹, R², and R³ independently represents an alkyl group having 1 to 10 carbon atoms, an aralkyl group having 7 to 10 carbon atoms, an aryl group having 6 to 10 carbon atoms, an unsaturated hydrocarbon group having 2 to 8 carbon atoms, or a monovalent organic group having a (meth)acryloyl group, an epoxy group, or an oxetanyl group; each of the alkyl group, the aralkyl group, the aryl group, the unsaturated hydrocarbon group, the (meth)acryloyl group, the epoxy group, and the oxetanyl group may be substituted with at least one selected from the group consisting of a halogen atom, a hydroxy group, an alkoxy group, an aryloxy group, an aralkyloxy group, and an oxy group; at least one of R¹, R², or R³ is a monovalent organic group having a (meth)acryloyl group, an epoxy group, or an oxetanyl group; R¹, R², and R³ may be the same as or different from each other; each of v, w, x, and y means a ratio with respect to a total amount of v, w, x, and y; w represents a positive number of 1 or less; and each of v, x, and y independently represents 0 or a positive number of less than 1.

2. The undercoat agent composition for layering an inorganic material layer according to claim 1, wherein x in Formula (1) represents a positive number of less than 1.

3. The undercoat agent composition for layering an inorganic material layer according to claim 1 or 2, wherein the dry film-forming method is a physical vapor deposition method.

4. The undercoat agent composition for layering an inorganic material layer according to any one of claims 1 to 3, which satisfies 0.3 ≤ {w/(v+w+x+y)} ≤ 1.0 and 0 ≤ {x/(v+w+x+y)} ≤ 0.7.

5. The undercoat agent composition for layering an inorganic material layer according to any one of claims 1 to 3, which satisfies 0.5 ≤ {w/(v+w+x+y)} ≤ 1.0 and 0 ≤ {y/(v+w+x+y)} ≤ 0.5.

6. The undercoat agent composition for layering an inorganic material layer according to any one of claims 1 to 5, wherein the polysiloxane compound has a viscosity of from 10 to 1,000,000 mPa s at 25°C.

7. A cured product for layering an inorganic material layer, which is a cured product of the undercoat agent composition for layering an inorganic material layer according to any one of claims 1 to 6.

8. A layered body, comprising the cured product for layering an inorganic material layer according to claim 7, a resin substrate, and an inorganic material layer.

9. The layered body according to claim 8, wherein 5 or less out of 25 squares are peeled off in an evaluation of adhesiveness of the inorganic material layer to the cured product for layering an inorganic material layer in a cross-cut peeling test.

10. A method of producing the cured product for layering an inorganic material layer according to claim 7, the method comprising a step of irradiating the undercoat agent composition for layering an inorganic material layer according to any one of claims 1 to 6 with an active energy ray, to cure the composition.

11. A method of producing the layered body according to claim 8 or 9, the method comprising a step of irradiating the undercoat agent composition for layering an inorganic material layer according to any one of claims 1 to 6 with an active energy ray, to cure the composition.
